# EUROPÄISCHE PATENTSCHRIFT

(11) **EP 1 983 573 B1**
(45) Veröffentlichungstag und Bekanntmachung des Hinweises auf die Patenterteilung: **30.06.2010**
(21) Anmeldenummer: 08160933.1
(22) Anmeldetag: 27.11.2003
(51) Int. Cl.: H01L 27/08

(54) **Integrierte Schaltungsanordnung enthaltend eine Kondensatoranordnung und Kondensatoranordnungen**
Integrated circuit comprising a condenser device and condenser devices
Circuit intégré comportant un agencement de condensateur et agencements de condensateur

(30) Priorität: 20.12.2002 DE 10260352
(43) Veröffentlichungstag der Anmeldung: 22.10.2008
(62) Teilanmeldung aus: 03782114.7
(73) Patentinhaber: Infineon Technologies AG, 85579 Neubiberg (DE)
(72) Erfinder: Bachmann, Jens, 04575, Neukieritzsch (DE); Föste, Bernd, 01097, Dresden (DE); Goller, Klaus, 93059 Regensburg (DE); Kriz, Jakob, 01689, Weinböhla (DE)
(74) Vertreter: Karl, Frank

(56) Entgegenhaltungen:
- WO-A-01/78093
- WO-A-98/00871
- US-A1- 2002 192 919
- US-B1- 6 198 617
- WATT M M ET AL: "Feasibility demonstration of a multi-level thin film BST capacitor technology" APPLICATIONS OF FERROELECTRICS, 1998. ISAF 98. PROCEEDINGS OF THE ELEVENTH IEEE INTERNATIONAL SYMPOSIUM ON MONTREUX, SWITZERLAND 24-27 AUG. 1998, PISCATAWAY, NJ, USA,IEEE, US, 24. August 1998 (1998-08-24), Seiten 11-14, XP010347302 ISBN: 0-7803-4959-8

## Beschreibung

Die Erfindung betrifft eine integrierte Schaltungsanordnung, die bspw. ein Halbleitersubstrat enthält, das eine Vielzahl aktiver Gebiete von elektronischen Bauelementen enthält. Das Halbleitersubstrat ist beispielsweise ein Siliziumchip. Die aktiven Gebiete sind beispielsweise Kanalgebiete von Feldeffekttransistoren oder aktive Bereiche von Bipolartransistoren.

Aufgrund der Vielzahl von elektronischen Bauelementen sind in der integrierten Schaltungsanordnung mindestens drei durch isolierende Zwischenlagen voneinander getrennte Metallisierungslagen enthalten. Eine Metallisierungslage erstreckt sich üblicherweise in einer Ebene. Die Metallisierungslage enthält Leitbahnen, die zum Anschluss der elektronischen Bauelemente dienen.

Außerdem enthält die integrierte Schaltungsanordnung elektrisch leitfähige Kontaktabschnitte, die quer, d.h. in Richtung der Normalen eines Halbleitersubstrates, zu den Metallisierungslagen liegen. Diese Kontaktabschnitte werden auch als sogenannte Vias bezeichnet.

Aus dem Fachaufsatz "High performance, low complexity 0.18 um SiGe BiCMOS Technology for Wireless Circuit Applications", N. Feilchenfeld u.a., IEEE BCTM 11.3, Seite 197 bis Seite 200, sind sogenannte Dual-MIM-Kondensatoren (Metal-Insulator-Metal) bekannt, die zu einer Verdoppelung der flächenbezogenen Kapazität führen. Der bekannte MIM-Kondensator mit drei Elektroden liegt zwischen zwei Metallisierungslagen.

Aus der WO 01/78093 A2 ist ein sogenanntes "top-down" Verfahren bekannt, bei dem zuerst ein Elektrodenstapel eines Kondensators erzeugt und danach die Elektroden sukzessive von oben nach unten hergestellt werden, wobei eine untere Elektrode jeweils größer als oder gleichgroß wie die unmittelbar darüber angeordnete Elektrode ist.

Aus der US 2002/0192919 A1, Figur 4A, ist eine Kondensatoranordnung bekannt, die eine mittlere Kondensatorplatte 89, 92 enthält, die von einer Kondensatorplatte 90, 88, 86 umgriffen wird, wobei sich die Kondensatorplatte 90, 88, 86 über zwei Metallisierungslagen M5 und M6 erstreckt. Zwischen den beiden Metallisierungslagen M5 und M6 befindet sich eine Zwischenlage 87, in der die Elektrode 89 angeordnet ist.

Die Patenschrift US 6,198,617 B1 zeigt eine Kondensatoranordnung mit elektrisch in Reihe geschalteten Elektroden in mehreren Metallisierungslagen.

Es ist Aufgabe der Erfindung, eine einfach aufgebaute Schaltungsanordnung mit Kondensatoranordnung anzugeben, wobei die Kondensatoranordnung insbesondere eine hohe Flächenkapazität, eine große Güte bzw. eine hohe Linearität hat. Außerdem sollen Kondensatoranordnungen angegeben werden, die mindestens eine erfindungsgemäße Kondensatoranordnung enthalten.

Die auf die Schaltungsanordnung bezogene Aufgabe wird durch eine Schaltungsanordnung mit den im Patentanspruch 1 angegebenen Merkmalen gelöst. Weiterbildungen sind in den Unteransprüchen angegeben.

Die Erfindung geht von der Überlegungen aus, dass allein durch Verwenden von Dielektrika mit großen Dielektrizitätskonstanten und minimalen Schichtdicken die Erhöhung der Flächenkapazität an eine Grenze gestoßen ist. Außerdem geht die Erfindung von der Überlegung aus, dass auch beim Verwenden von MIM-Kondensatoren mit mehr als zwei Elektroden zwischen zwei Metallisierungslagen schnell eine Grenze in der Anzahl der Elektroden erreicht wird. So ist der Abstand zwischen verschiedenen Metallisierungslagen beispielsweise 1 µm.

Deshalb enthält die erfindungsgemäße Schaltungsanordnung eine Kondensatoranordnung, die zu zwei ineinandergreifenden Kondensatorplatten über Kontaktabschnitte verschaltete Elektroden enthält. Die Elektroden der Kondensatoranordnung sind in mindestens zwei Zwischenlagen angeordnet. Mit anderen Worten erstreckt sich die erfindungsgemäße Kondensatoranordnung über mehrere Zwischenlagen bzw. auch über mehrere Metallisierungslagen.

Durch diese Maßnahme wird erreicht, dass sich die Flächenkapazität bei Verwendung der bisher üblichen Maßnahmen sogar bei Verwendung von nur einer Elektrode je Zwischenlage bei Einbeziehung von beispielsweise fünf Zwischenlagen auf den fünffachen Wert im Vergleich zu einem Einfach-MIM-Kondensator steigern lässt. Werden in einer Zwischenlage drei oder noch mehr Elektroden angeordnet, so steigt die Flächenkapazität bei Einbeziehung von beispielsweise fünf Zwischenlagen auf das Zehnfache. Steigt die Flächenkapazität so verringert sich die für eine Kondensatoranordnung vorgegebener Kapazität benötigte Chipfläche.

Außerdem bietet die erfindungsgemäße Kondensatoranordnung die Möglichkeit, mindestens eine Elektrode je Zwischenlage nach demselben Layout zu fertigen. Dadurch werden die zusätzlichen Kosten zur Entwicklung von Masken gesenkt.

Ein anderer Vorteil der erfindungsgemäßen Schaltungsanordnung besteht darin, dass jede Elektrode der Kondensatoranordnung auf einfache Art und bei geringer benötigter Chipfläche mit einer hohen Dichte an Kontaktlöchern elektrisch angeschlossen werden kann. Die Folge davon ist eine hohe Güte der Kapazität. Ferner wird der Effekt der Abhängigkeit der Kapazität von der Spannung bzw. von der Polung der Elektroden verringert. Dies ist ein entscheidender Vorteil für Hochfrequenzprodukte, z.B. für Mobilfunkanwendungen oder drahtlose lokale Netze.

Bei einer Weiterbildung der erfindungsgemäßen Schaltungsanordnung liegt mindestens eine Elektrode oder eine Teilelektrode der Kondensatoranordnung in einer Metallisierungslage. Damit wird die Elektrodenanzahl der übereinanderliegenden Elektroden in der Kondensatoranordnung auf einfache Art erhöht.

Bei einer Ausgestaltung enthält mindestens eine Elektrode der Kondensatoranordnung eine in einer Metallisierungsebene liegende Teil-Elektrode und eine zwischen zwei Metallisierungsebenen liegende Teil-Elektrode. Die beiden Teil-Elektroden sind über mindestens einen Kontaktabschnitt, vorzugsweise aber über mehrere Kontaktabschnitte miteinander elektrisch leitend verbunden. Durch diese Maßnahme wird erreicht, dass die aus Teil-Elektroden bestehende Elektrode Zwischenräume überbrückt, die in den Zwischenlagen nicht für die Kondensatoranordnung benötigt werden. Damit lassen sich Kondensatoranordnungen auf einfache Art herstellen, die in einer Zwischenlage einen Elektrodenstapel enthalten, dessen Höhe geringer als die Höhe der Zwischenlage ist.

Bei einer anderen Weiterbildung sind Elektroden der Kondensatoranordnung in mindestens drei oder in mehr als drei Zwischenlagen angeordnet. Je mehr Zwischenlagen in die Kondensatoranordnung einbezogen werden, um so höher ist die Flächenkapazität und um so öfter lassen sich Maskenlayouts bzw. Teile von Maskenlayouts mehrfach nutzen.

Bei einer nächsten Weiterbildung hat mindestens eine in einer Zwischenlage angeordnete Elektrode den gleichen Umriss wie eine andere in einer anderen Zwischenlage angeordnete Elektrode. Durch diese Maßnahmen lassen sich Teillayouts von Masken für diese Elektrode mehrfach bei der Herstellung einer Schaltungsanordnung nutzen.

Bei einer nächsten Weiterbildung sind die Elektroden mit gleichem Umriss genau übereinander angeordnet, d.h. sie fluchten entlang ihres gesamten Randes in Normalenrichtung einer die Kondensatoranordnung tragenden Substratfläche, z.B. ein Halbleitersubstrat. Beim Übernehmen von Teillayout-Daten der Masken kann durch diese Maßnahme neben den Umrissen sogar die Position innerhalb einer Ebene beibehalten werden.

Bei einer nächsten Weiterbildung sind zwischen zwei Metallisierungslagen mindestens zwei Elektroden oder mindestens drei Elektroden angeordnet. Dabei bezieht sich der Begriff Elektrode im Rahmen diese Beschreibung auch auf eine Teilelektrode, sofern nichts anderes angegeben wird.

Bei einer Weiterbildung gibt es mindestens drei in der Kondensatoranordnung aufeinanderfolgende Elektroden, die mit einer Anzahl von Lithografieverfahren strukturiert worden sind, die kleiner als die Anzahl der aufeinanderfolgenden Elektroden ist. So lassen sich beispielsweise drei Elektroden mit nur zwei Lithografieverfahren strukturieren, wenn in einem ersten Lithografieverfahren die beiden oberen Elektroden und im zweiten Lithografieverfahren die oberste und die unterste Elektrode strukturiert werden. Durch diese Maßnahme sinkt der Aufwand für die Masken weiter, weil weniger Masken erforderlich sind, die gegebenenfalls auch in mehreren Zwischenlagen verwendet werden können.

Bei einer nächsten Weiterbildung ist jede Elektrode mit mehreren Kontaktabschnitten angeschlossen. Durch diese Maßnahme verringert sich der Kontaktwiderstand. Die Güte des Kondensators und seine Linearität steigen.

Bei einer Ausgestaltung beträgt die Kontaktfläche mindestens einer in einer Zwischenlage liegenden Teil-Elektrode mehr als 30 % (Prozent) oder mehr als 50 % der Grundfläche dieser Teilelektrode. Die Teil-Elektroden lassen sich in der Kondensatoranordnung ohne zusätzliche Chipfläche mit einer sehr großen Kontaktfläche anschließen.

Bei einer nächsten Weiterbildung ist die Kontaktfläche zum Anschluss mindestens einer weiteren Elektrode, die keine Teil-Elektrode ist, gleich der Kontaktfläche zum Anschluss der Teil-Elektrode. Vorzugsweise sind alle Elektroden der Kondensatoranordnung über gleiche Kontaktflächen angeschlossen. Durch diese Maßnahme erhöht sich die Linearität. Es verringert sich die Abhängigkeit von Spannung bzw. Polung, so dass die Kondensatoranordnung insbesondere für Hochfrequenzanwendungen geeignet ist, d.h. für Anwendungen mit Umladevorgängen auf der Kondensatoranordnung im oberen Kilohertzbereich oder sogar im Megahertzbereich.

Bei einer nächsten Weiterbildung sind die metallischen Abschnitte der Metallisierungslagen aus Kupfer, aus Aluminium, aus einer Kupferlegierung oder aus einer Aluminiumlegierung hergestellt. Die Metallisierungslagen haben eine Dicke größer als 100 nm oder größer als 150 nm. Beispielsweise werden Metallisierungslagen mit einer Dicke von 500 nm verwendet.

Die metallischen Abschnitte der Metallisierungslagen, insbesondere die Elektroden bzw. Teil-Elektroden, lassen sich an zwei Flächen, d.h. von oben und von unten kontaktieren. Dagegen werden Elektroden in Zwischenlagen nur an ihrer oberen Elektrodenfläche kontaktiert.

Als Material für die Elektroden in Zwischenlagen wird bei einer Ausgestaltung ein Metall oder eine Metalllegierung eingesetzt. Insbesondere bei Verwenden von Metallnitride, z.B. von Titannitrid, Tantalnitrid oder Wolframnitrid lassen sich die Elektroden in Zwischenlagen sehr dünn ausführen. Bei einer Weiterbildung sind die Elektroden in Zwischenlagen dünner als 100 nm oder sogar dünner als 60 nm, beispielsweise 45 nm. Durch Verwenden solch dünner Elektrodenschichten lässt sich die Höhe der Kondensatoranordnung klein halten. Dies gilt insbesondere dann, wenn mehr als eine Elektrode je Zwischenlage ausgebildet wird.

Das Dielektrikum zwischen den Elektroden ist bei einer Ausgestaltung ein Oxid, insbesondere Siliziumdioxid. Jedoch werden alternativ auch Nitride verwendet, beispielsweise Siliziumnitrid. Auch Doppel- oder Mehrfachschichten aus dielektrischen Materialien werden eingesetzt.

Die Erfindung betrifft außerdem Kondensatoranordnungen, d.h. einen Satz von mindestens zwei Kondensatoranordnungen. Die Kondensatoranordnungen sind bis auf geometrische Entwürfe zum Festlegen der Lage der Kontaktabschnitte nach den gleichen geometrischen Entwürfen gefertigt worden. So sind insbesondere die Elektroden in Zwischenlagen in beiden Kondensatoranordnungen gleich. Mindestens eine der Kondensatoranordnungen ist wie eine erfindungsgemäße Kondensatoranordnung oder eine ihrer Weiterbildungen aufgebaut. Außerdem ist zum Anschluss einer Elektrode in der einen Kondensatoranordnung mindestens ein Kontaktabschnitt vorhanden, der in der anderen Kondensatoranordnung nicht vorhanden ist, d.h. fehlt, so dass mindestens eine Elektrode in der anderen Kondensatoranordnung nicht angeschlossen ist.

Durch diese Maßnahme wird erreicht, dass Kondensatoranordnungen unterschiedlicher Kapazität auf einfache Art und Weise durch Einfügen oder Weglassen eines Kontaktabschnitts oder mehrerer Kontaktabschnitte bei sonst gleichem Herstellungsprozess gefertigt werden können.

Bei einer Weiterbildung hat die angeschlossene Elektrode bezüglich der einen Kondensatoranordnung die gleiche Lage wie die nicht angeschlossene Elektrode bezüglich der anderen Kondensatoranordnung.

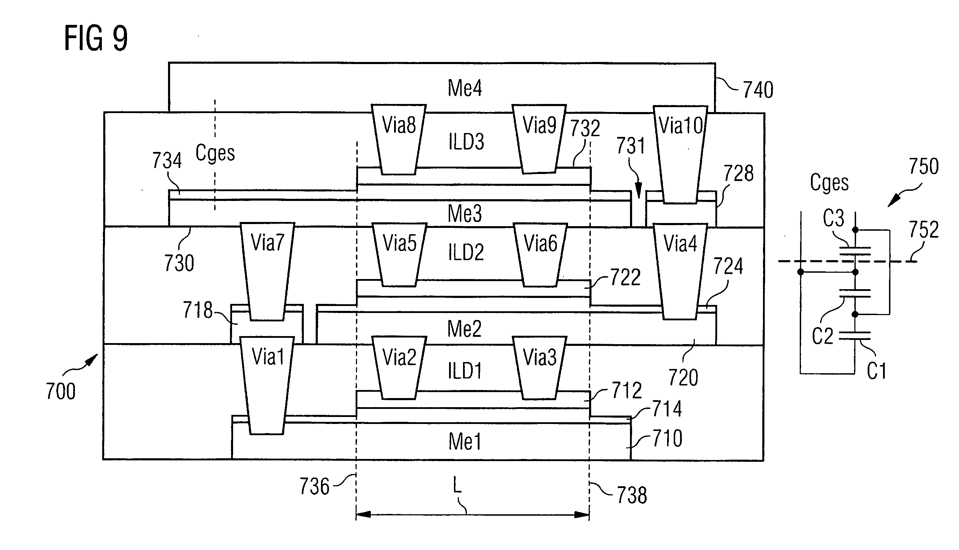

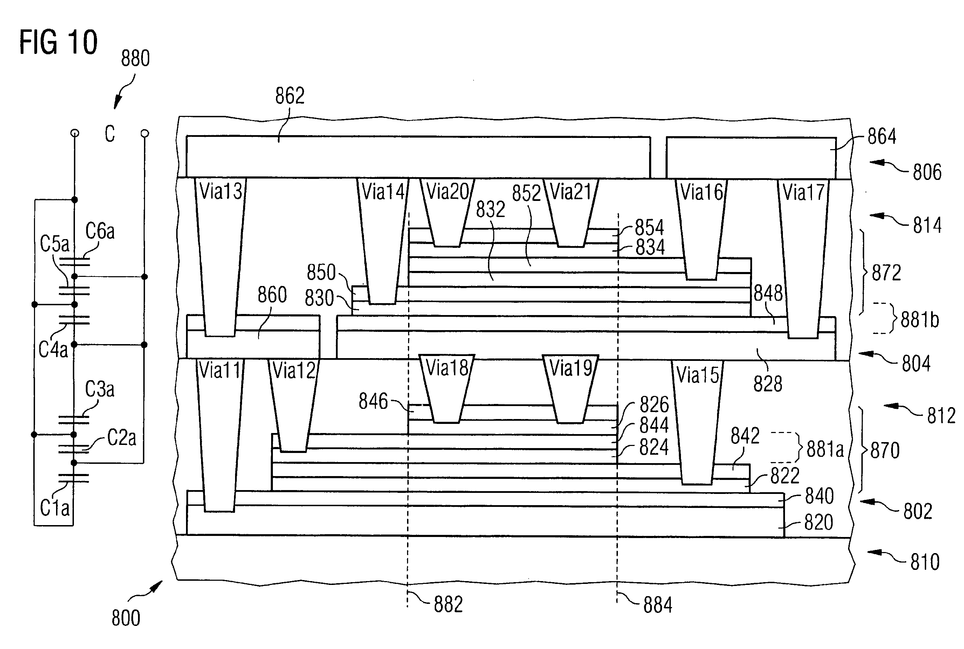

Im Folgenden werden Ausführungsbeispiele der Erfindung an Hand der beiliegenden Zeichnungen, Figur 9 und Figur 10, erläutert, wobei die anderen Figuren dem besseren Verständnis der Figuren 9 und 10 dienen. Darin zeigen:
- Figur 1: eine Zwischenstufe bei der Herstellung einer Kondensatoranordnung mit drei Elektroden,
- Figur 2: eine weitere Zwischenstufe bei der Herstellung der Kondensatoranordnung mit drei Elektroden,
- Figur 3: einen Kondensator mit drei Elektroden,
- Figuren 4A bis 4C: Ansichten eines weiteren Kondensators mit drei Elektroden,
- Figuren 5A bis 5C: Zwischenstufen bei einem zweiten Lithografiever- fahren zum Herstellen einer Kondensatoranordnung mit drei Elektroden unterschiedlicher Dicke,
- Figuren 6A bis 6C: einen Vergleich des Flächenverbrauchs für ver- schiedene Kondensatoranordnungen,
- Figuren 7A bis 7D: Herstellungsstufen bei der Herstellung einer Kondensatoranordnung mit neun Elektroden,
- Figur 8: eine Kondensatoranordnung mit neun Elektroden,
- Figur 9: eine sich über vier Metallisierungslagen erstre- ckende Kondensatoranordnung mit drei Einfach-MIM- Kondensatoren, und
- Figur 10: eine sich über drei Metallisierungslagen erstre- ckende Kondensatoranordnung mit zwei Tripel-MIM- Kondensatoren,
- Figur 11A: eine Herstellungsstufe bei der Herstellung einer Kondensatoranordnung,
- Figur 11B: die Kondensatoranordnung nach dem Trockenätzen einer Elektrodenschicht,
- Figur 11C: die Kondensatoranordnung nach einem nasschemi- schen Reinigungsschritt zum Entfernen von Resten der Elektrodenschicht, und
- Figur 11D: weitere Herstellungsstufen der Kondensatoranord- nung.

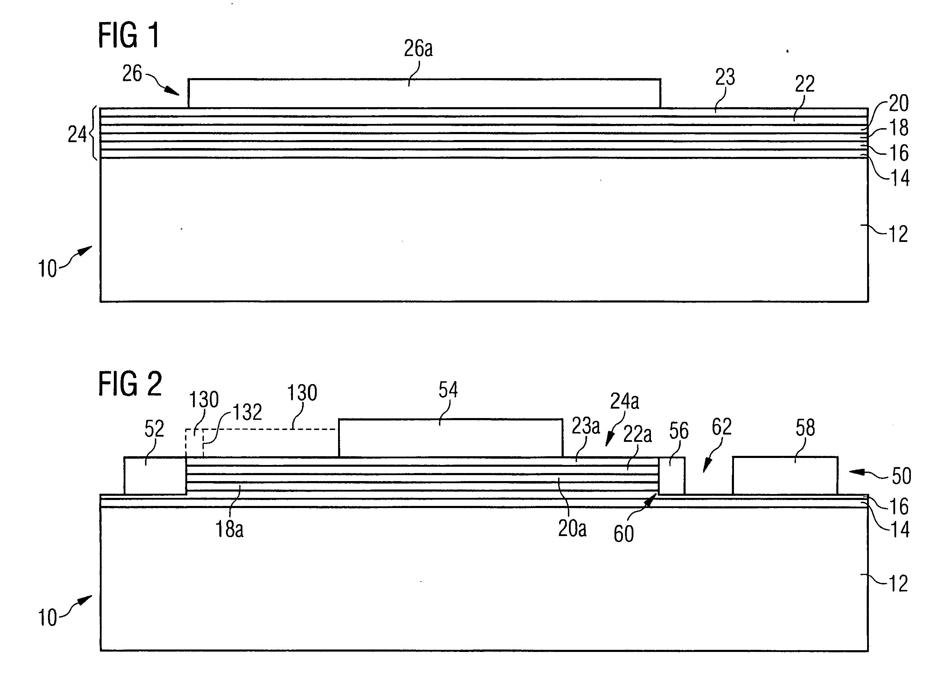

Figur 1 zeigt eine Zwischenstufe bei der Herstellung einer Kondensatoranordnung 10, die auf einer Dielektrikumschicht 12 angeordnet ist. Die Dielektrikumschicht 12 bildet das Dielektrikum zwischen verschiedenen Leitbahnen einer Metallisierungslage im Inneren einer integrierten Schaltungsanordnung. Beispielsweise hat die Dielektrikumschicht 21 eine Dicke von 300 nm und besteht aus Siliziumdioxid.

Auf die Dielektrikumschicht 12 wird eine Grundelektrodenschicht aufgebracht, z.B. aufgesputtert. Im Ausführungsbeispiel bestehen sämtliche Elektrodenschichten aus Titannitrid TiN. Die Elektrodenschichten haben beispielsweise eine Dicke von jeweils 50 nm.

Nach dem Aufbringen der Grundelektrodenschicht 14 wird eine Grunddielektrikumschicht 16 aufgebracht. Die Grunddielektrikumschicht 16 besteht beispielsweise aus Siliziumnitrid SiN und wird beispielsweise aus der Gasphase abgeschieden. Die Dicke der Grunddielektrikumschicht 16 beträgt im Ausführungsbeispiel ebenfalls 50 nm.

Nach dem Abscheiden der Grunddielektrikumschicht 16 wird eine Mittelelektrodenschicht 18 aus Titannitrid TiN abgeschieden, die ebenfalls eine Dicke von 50 nm hat. Anschließend wird eine Deckdielektrikumschicht 20 aus Siliziumnitrid in einer Dicke von 50 nm aufgebracht. Dann wird eine Deckelektrodenschicht 22 aus Titannitrid mit einer Dicke von 50 nm erzeugt. Den Abschluss eines die Schichten 14 bis 22 enthaltenden Schichtstapels 24 bildet eine Siliziumnitridschicht 23 mit einer Dicke von 50 nm. Die Schichten des Schichtstapels 24 liegen parallel zu einer Waferoberfläche eines in Figur 1 nicht dargestellten Wafers, der auch die Dielektrikumschicht 12 trägt.

Auf den Schichtstapel 24 wird eine Fotolackschicht 26 aufgebracht und gemäß den Mustern einer Fotomaske belichtet. Die belichtete Fotolackschicht 26 wird entwickelt, wobei ein Fotolackschichtbereich 26a auf dem Schichtstapel 24 verbleibt.

Wie in Figur 2 dargestellt, wird der Schichtstapel 24 anschließend mit einem Trockenätzprozess geätzt, wobei gemäß dem Fotolackschichtbereich 26a zunächst die Siliziumnitridschicht 23, dann die Deckelektrodenschicht 22, die Deckdielektrikumschicht 20 und die Mittelelektrodenschicht 18 strukturiert werden. Es entstehen eine vorstrukturierte Deckelektrode 22a, ein Deckdielektrikum 20a und eine Mittelelektrode 18a. Die Trockenätzung der Mittelelektrode 18a wird selektiv zur Grunddielektrikumschicht 16 geführt, so dass die Grunddielektrikumschicht 16 durch die Ätzung kaum angegriffen wird. In den Figuren ist der Ätzangriff übertrieben stark gezeichnet. Die Dielektrikumschicht 23a und die Deckdielektrikumschicht 20 werden ohne Veränderung der Ätzbedingungen oder unter Veränderung der Ätzbedingungen geätzt.

Beispielsweise wird der Ätzprozess unterteilt in:
1. zeitgesteuerte Ätzung der Dielektrikumschicht 23,
2. Ätzung der Deckelektrodenschicht 18 mit einer Ätzung, die hochselektiv zur Deckdielektrikumschicht 20 ist. Erfassen dieses Endpunktes zum Beenden des Ätzens und zur Prozesskontrolle.
3. Ausführen einer unselektiven zeitgesteuerten Ätzung der Deckdielektrikumschicht 20 unselektiv zur Mittelelektrodenschicht 18.
4. Danach wird wiederum eine hochselektive Ätzung mit Endpunkterkennung auf der Grunddielektrikumschicht 16 durchgeführt.

Durch diese Verfahrensweise ist ein hinreichend großes Prozessfenster sichergestellt.

Wie in Figur 2 weiter dargestellt, wird auf den bereits vorstrukturierten Schichtstapel 24a und die freiliegenden Bereiche der Grunddielektrikumschicht 16 eine Fotolackschicht 50 aufgebracht. Die Fotolackschicht 50 wird gemäß einer zweiten Fotomaske belichtet und entwickelt. Nach dem Entwickeln verbleiben von der Fotolackschicht 50 Fotolackbereiche 52 bis 58. Der Fotolackbereich 52 liegt auf der Grunddielektrikumschicht 16 und grenzt an die linke Seite des Schichtstapels 24a an und legt fest, wie weit eine zu erzeugende Grundelektrode über die Mittelelektrode 18a auf der linken Seite der Kondensatoranordnung 10 hinausragt. Der Fotolackbereich 54 liegt auf der bereits vorstrukturierten Dielektrikumschicht 23a in einem mittleren Bereich. Der Fotolackbereich 54 legt die Lage der Deckelektrode fest und gleichzeitig den Überstand der Mittelelektrode 18a bezüglich der fertiggestellten Deckelektrode.

Ein Fotolackbereich 56 liegt auf der Grunddielektrikumschicht 16 an der rechten Seite des Schichtstapels 24a. Durch den Fotolackbereich 56 wird ein Randbereich 60 der Grunddielektrikumschicht 16 vor weiteren Ätzangriffen geschützt. Außerdem legt der Fotolackbereich 56 den Überstand der zu erzeugenden Grundelektrode bezüglich der Mittelelektrode 18a auf der rechten Stapelseite fest.

Der Fotolackbereich 58 ist durch eine Aussparung 62 vom Fotolackbereich 56 getrennt und dient zum Festlegen der Struktur einer Leitbahn in der Grundelektrodenschicht 16. Diese Leitbahn soll nicht zur Kondensatoranordnung 10 gehören.

Anschließend werden mittels eines Trockenätzprozesses die vorstrukturierte Deckelektrode 52a und die Grundelektrodenschicht 14 geätzt. Dabei wird unter Ausnutzung der Selektivität der Metallätzung gegenüber den Dielektrika gezielt die folgende Stapelfolge geätzt:
- zeitgesteuertes Ätzen der vorstrukturierten Dielektrikumschicht 23a,
- Ätzen der metallischen vorstrukturierten Deckelektrode 22a mit Stopp im vorstrukturierten Deckdielektrikum 20a.

Dabei werden gleichzeitig die Grunddielektrikumschicht 16 und danach die Grundelektrodenschicht 14 strukturiert.

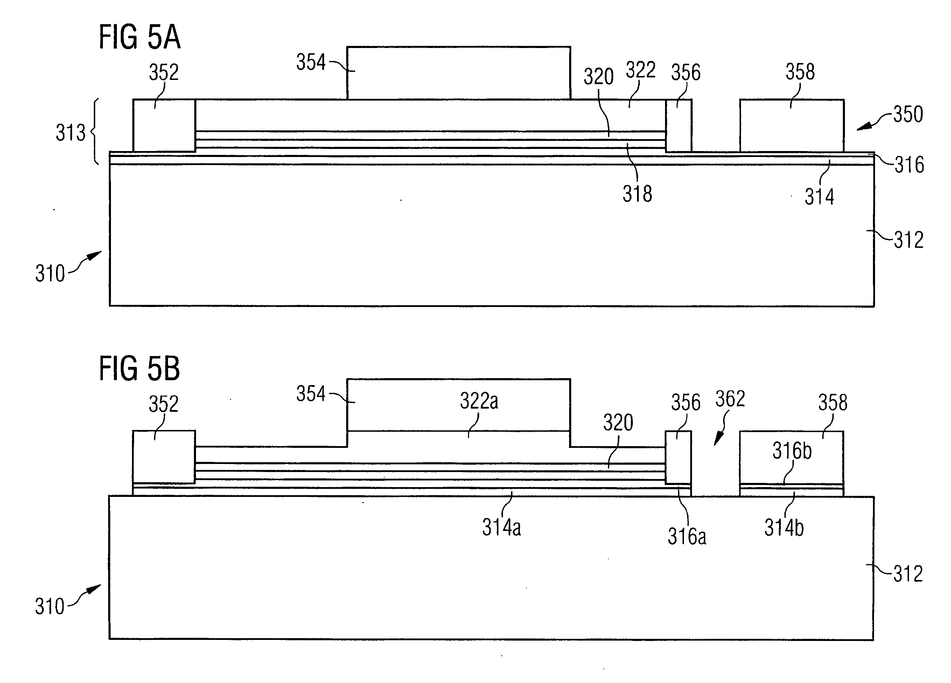

Gegebenenfalls wird gezielt überätzt, um sicher in die Dielektrikumschicht 12 zu gelangen. Eine andere Möglichkeit zur Vergrößerung des Prozessfensters wird unten an Hand der Figuren 5A bis 5C näher erläutert.

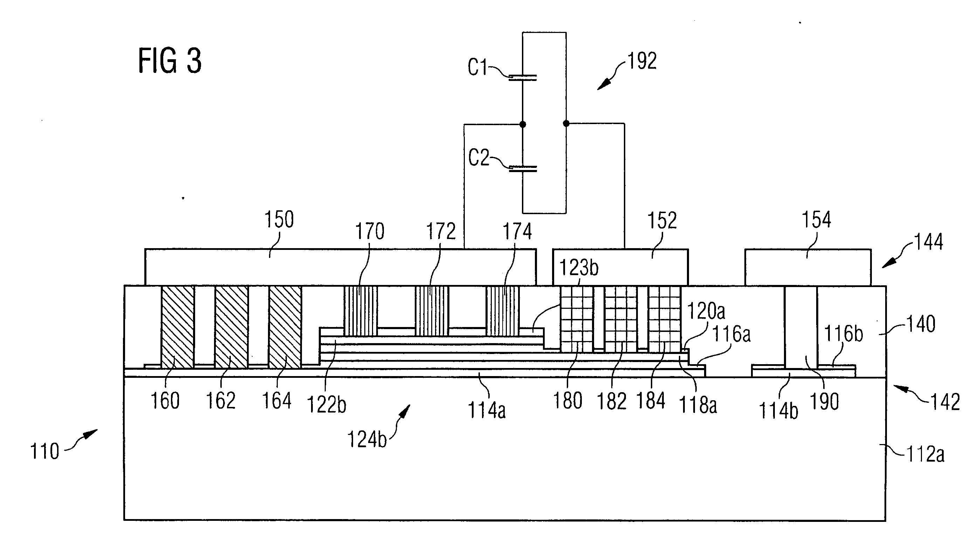

Bei dem an Hand der Figuren 1 und 2 erläuterten Verfahren entsteht eine Kondensatoranordnung 10, die einer in Figur 3 gezeigten Kondensatoranordnung 110 bis auf geringe Unterschiede gleicht. Gleiche Bestandteile der Kondensatoranordnung 110 wie in der Kondensatoranordnung 10 werden mit den gleichen Bezugszeichen, jedoch mit einer vorangestellten 1 bezeichnet. So wird die Grundelektrode mit dem Bezugszeichen 114a bezeichnet. Eine durch einen dem Fotolackbereich 58 entsprechenden Fotolackbereich strukturierte Leitbahn 114b ist ebenfalls in Figur 3 dargestellt.

Auf der Grundelektrode 114a befindet sich eine durch die Ätzung zum Erzeugen des Schichtstapels 124b nur leicht angegriffene Grunddielektrikumschicht 116a. Über der Leitbahn 114b befindet sich ein verbliebener Bereich 116b der Dielektrikumschicht, aus der auch die Dielektrikumschicht 116a gebildet wird.

Beim Strukturieren des Schichtstapels 124b wurden die Deckelektrode 122b und die Mittelelektrode 118a an ihren linken Rand zueinander fluchtend in einer Normalen des Halbleiterwafers ausgebildet. Dies wird dadurch erreicht, dass der die Dielektrikumschicht 123a bedeckende Lack bis an die linke Kante der Dielektrikumschicht 123a nach dem Entwickeln heranreicht, siehe gestrichelte Linie 130 in Figur 2. Alternativ lässt sich durch eine Verkürzung des Fotolackbereichs eine Strukturierung erreichen, bei der Schäden im Randbereich des Deckdielektrikums 120a durch eine linksseitige Verkürzung der Deckelektrode 122b schaltungstechnisch unwirksam gemacht werden, siehe gestrichelte Linie 132 in Figur 2.

Wie in der Schnittdarstellung gemäß Figur 3 gut zu erkennen ist, wurde anschließend auf den Schichtstapel 124b eine dielektrische Schicht 140 abgeschieden, beispielsweise aus Siliziumdioxid. Die dielektrische Schicht 140 bildet ein Dielektrikum zwischen den Metallisierungslagen 142 und 144. Die Metallisierungslage 142 enthält beispielsweise die Grundelektrode 114a und die Leitbahn 114b. Die Metallisierungslage 144 enthält u.a. drei Leitbahnen 150 bis 154, beispielsweise aus Aluminium. Die Dicke der Metallisierungslage 144 ist im Ausführungsbeispiel größer als die Dicke der Metallisierungslage 142.

Die Leitbahn 150 dient zum elektrischen Verbinden der Grundelektrode 114a und der Deckelektrode 122b. Von der Leitbahn 150 führen drei Viafüllungen 160 bis 164 zur Grundelektrode 114a. Die Viafüllungen 160 bis 164 gehören zu drei Reihen von Viafüllungen, die sich auf dem linken Bereich der Grundelektrode 114a erstrecken.

Von der Leitbahn 150 bis zur Deckelektrode 122b führen drei Viafüllungen 170 bis 174, die Bestandteil von drei Reihen sich auf der Deckelektrode 122b erstreckenden Viafüllungen sind.

Von der Leitbahn 152 bis zur Mittelelektrode 118a führen drei Viafüllungen 180 bis 184, die Bestandteil von drei Viareihen sind, die sich auf einem rechten Bereich der Mittelelektrode 118a erstrecken. Dieser Bereich wird nicht von der Deckelektrode 122b bedeckt.

Von der Leitbahn 154 führt eine Viafüllung 190 zur Leitbahn 114b. Beim Ätzen von Kontaktlöchern für die Viafüllungen 160 bis 190 wurden die Dielektrikumschichten des Schichtstapels 124b bzw. die Dielektrikumschicht 116b vom Boden der Kontaktlöcher für die Viafüllungen 160 bis 190 durchdrungen.

Damit enthält die Kondensatoranordnung 110a zwei Kondensatoren C1 und C2, die parallel geschaltet sind, siehe Schaltskizze 192 in Figur 3.

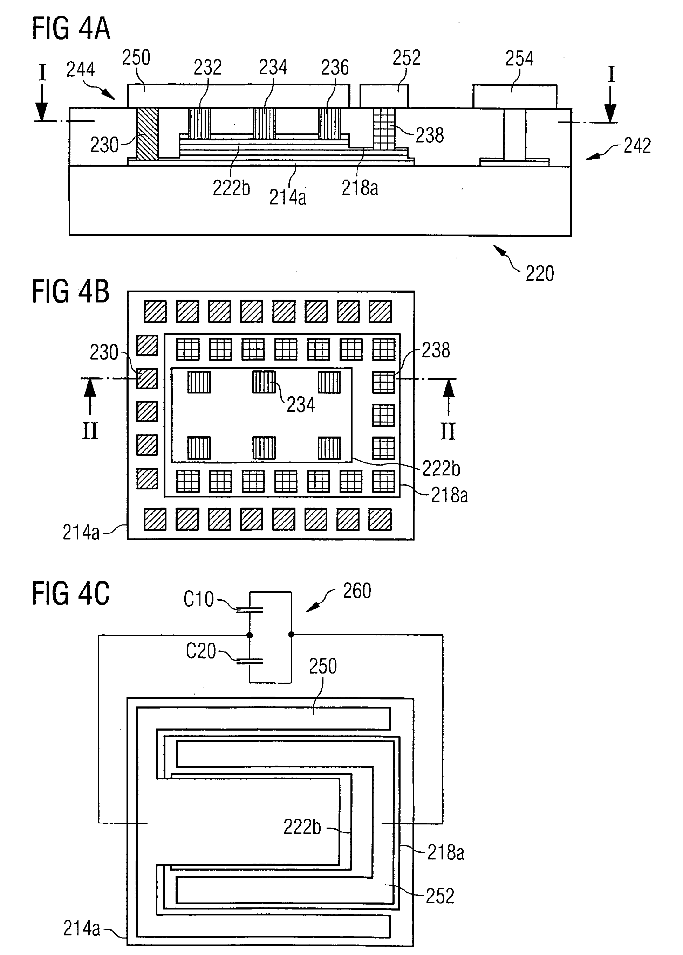

Figur 4A zeigt eine Schnittdarstellung durch eine Kondensatoranordnung 220 entlang einer Schnittebene II, siehe Figur 4B. Die Kondensatoranordnung 220 wurde mit dem oben an Hand der Figuren 1 bis 3 erläuterten Verfahren hergestellt. So enthält die Kondensatoranordnung 220 eine rechteckförmige Grundelektrode 214a, eine Mittelelektrode 218a und eine Deckelektrode 222b. Eine obere Metallisierungsebene 244 enthält u.a. drei Leitbahnen 250, 252 und 254. Die Leitbahn 250 dient zum Verbinden von Grundelektrode 214a und Deckelektrode 222b. Die Leitbahn 252 dient zum Anschließen der Mittelelektrode 218a. In Figur 4A sind eine Viafüllung 230 zwischen der Leitbahn 250 und der Grundelektrode 214a, drei Viafüllungen 232 bis 236 zwischen der Leitbahn 250 und der Deckelektrode 222b sowie eine Viafüllung 238 zwischen der Leitbahn 252 und der Mittelelektrode 218a in der Schnittebene II angeordnet. Die Leitbahn 258 dient zum Anschluss einer Leitbahn in der Metallisierungslage 242.

Figur 4B zeigt eine Draufsicht auf die Kondensatoranordnung 210 geschnitten in einer Schnittebene I, deren Lage in Figur 4A eingetragen ist. Die Grundelektrode 214a hat den größten Flächeninhalt. Die Mittelelektrode 218a hat einen kleineren Flächeninhalt als die Grundelektrode 214a. Die Deckelektrode 222b hat einen kleineren Flächeninhalt als die Mittelelektrode 218a.

Die Mittelelektrode 218a ist an den rechten Rand der Grundelektrode 214a näher rangerückt als an den linken Rand der Grundelektrode 214. Dadurch können Viafüllungen 230 am unteren Rand der Grundelektrode 214a, am linken Rand der Grundelektrode 214a und am oberen Rand der Grundelektrode 214a angeordnet werden.

Die Deckelektrode 222b ist dagegen näher am linken Rand der Mittelelektrode 218a angeordnet als am rechten Rand der Mittelelektrode 218a. Dadurch lassen sich Viafüllungen 238 am unteren Rand der Mittelelektrode 218a, am rechten Rand der Mittelelektrode 218a und am oberen Rand der Mittelelektrode 218a anordnen.

Die Deckelektrode 222b ist im Ausführungsbeispiel mit sechs Viafüllungen 234 kontaktiert, die entweder in einer Ecke oder in der Mitte einer Längsseite der Deckelektrode 222b enden.

Figur 4C zeigt eine Draufsicht auf die Kondensatoranordnung 220a. Gut zu erkennen ist die Führung der Leitbahnen 250 und 252 in der Metallisierungslage 244. In Figur 4C ist außerdem eine Schaltskizze 260 dargestellt, welche die Verschaltung von Kondensatoren C10 und C20 der Kondensatoranordnung 220a zeigt. Die beiden Kondensatoren C10 und C20 sind elektrisch parallel zu einander geschaltet.

Bei einem anderen Ausführungsbeispiel wird die Grundelektrode 214a über die Metallisierungslage 242 oder eine unter dieser Metallisierungslage 242 liegende Metallisierungslage angeschlossen.

Bei der Herstellung der Kontaktlöcher wird für die Viafüllungen eine Oxidätzung durchgeführt, die hochselektiv gegenüber dem Elektrodenmaterial oder gegenüber dem Dielektrikum ist. Vorzugsweise wird eine endpunktgesteuerte Ätzung eingesetzt, da für jede Elektrode die Tiefe der Kontaktlöcher unterschiedlich ist.

Die Figuren 5A bis 5C zeigen Zwischenstufen bei einem zweiten Lithografieverfahren gemäß einem weiteren Ausführungsbeispiel. Eine Kondensatoranordnung 310 wird auf einer Dielektrikumschicht 312 erzeugt, die das Dielektrikum zwischen zwei benachbarten Metallisierungsebenen bildet und beispielsweise Siliziumdioxid enthält. Auf der Dielektrikumschicht 312 werden nacheinander zur Erzeugung eines Schichtstapels 313 eine Titannitridschicht 314, eine Siliziumnitridschicht 316, eine Titannitridschicht 318, eine Siliziumnitridschicht 320 und eine Titannitridschicht 322 abgeschieden. Die Schichten 314 bis 320 haben alle die gleiche Dicke von 50 nm oder 45 nm (Nanometer). Die obere Titannitridschicht 322 des Schichtstapels 313 ist dagegen mehr als doppelt so dick wie die Titannitridschicht 318, nämlich im Ausführungsbeispiel etwa 200 nm.

Aufgrund der vergrößerten Dicke der oberen Titannitridschicht 322 ist auf dem Schichtstapel 313 keine weitere Dielektrikumschicht aufzubringen, bevor mit der Strukturierung des Schichtstapels 313 begonnen wird. Mit Hilfe einer in Figur 5A nicht dargestellten Fotolackschicht werden nacheinander die obere Titannitridschicht 322, die Dielektrikumschicht 320 und die Titannitridschicht 318 strukturiert. Dabei wird so, wie oben an Hand der Figuren 1 und 2 erläutert, vorgegangen. Insbesondere werden bei einer Ausgestaltung die Titannitridschichten 322 und 318 mit Hilfe von Endpunkterfassungen geätzt. Das bedeutet, dass im Ätzgas Spuren des Materials der Dielektrikumschicht 320 bzw. 316 bzw. eines charakteristischen Reaktionsproduktes dieses Materials mit einem Ätzgas erfasst werden, beispielsweise mit Hilfe einer Spektralanalyse.

Anschließend wird eine Fotolackschicht 350 auf den vorstrukturierten Schichtstapel 313 und auf die freiliegenden Teile der Siliziumnitridschicht 316 aufgebracht. Mit Hilfe einer Belichtung und eines Entwicklungsvorganges werden Fotolackbereiche 352 bis 358 erzeugt, die in dieser Reihenfolge bezüglich des Schichtstapels 313 an den gleichen Stellen angeordnet sind, wie die Fotolackschichtbereiche 52 bis 58 bezüglich des Schichtstapels 24a. Jedoch liegt der Fotolackbereich 354 unmittelbar auf der oberen vorstrukturierten Titannitridschicht 322 auf. Die Fotolackschicht 350 ist dicker ausgebildet als die Fotolackschicht 50, damit die Kanten des Schichtstapels 313 durch die Fotolackbereiche 352 und 356 vollständig bedeckt sind.

Nach dem Strukturieren der Fotolackschicht 350 wird, wie in Figur 5B dargestellt, die untere Siliziumnitridschicht 316 strukturiert, wobei ein Grunddielektrikum 316a und ein Dielektrikum 316b entstehen. Diese Ätzung wird beispielsweise zeitgesteuert durchgeführt. Danach wird die untere Titannitridschicht 314 strukturiert, wobei eine Grundelektrode 314a und eine Leitbahn 314b entstehen.

Diese Ätzung wird mit Hilfe einer Endpunkterfassung durchgeführt, bei der Material der Dielektrikumschicht 312 bzw. eines charakteristischen Ätzproduktes dieses Materials mittels einer Spektralanalyse erfasst wird. Zu dem Zeitpunkt, zu dem der Boden einer zwischen dem Fotolackbereich 356 und 358 liegenden Aussparung 362 die Dielektrikumschicht 312 erreicht, ist die Titannitridschicht 322 erst teilweise strukturiert, siehe Titannitridschicht 322a. Insbesondere liegt die vorstrukturierte Siliziumnitridschicht 320 noch nicht frei.

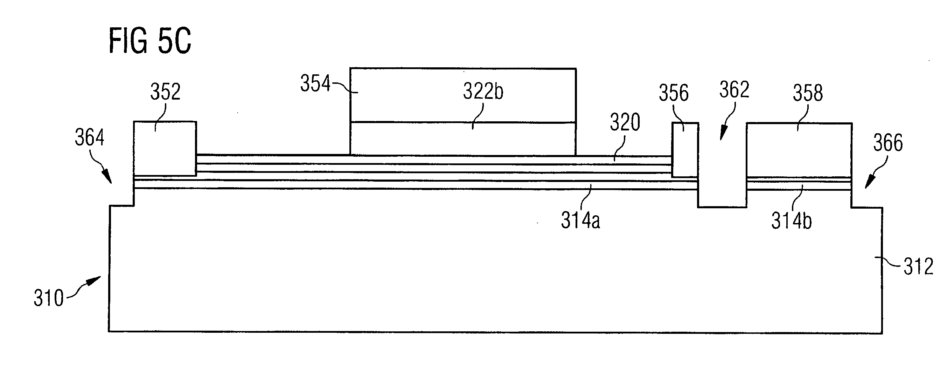

Danach wird eine weitere selektive Ätzung durchgeführt, bei der die Titannitridschicht 322a vollständig strukturiert wird. Wie in Figur 5C dargestellt, entsteht aus der bereits vorstrukturierten Titannitridschicht 322a dabei eine Deckelektrode 322b. Die Strukturierung der Deckelektrode 322b wird mit Hilfe einer Endpunkterfassung beendet, sobald in dem Ätzgas Material der Dielektrikumschicht 320 bzw. eines charakteristischen Ätzproduktes dieses Materials erfasst wird. Zu diesem Zeitpunkt reicht der Boden der Aussparung 362 schon weit in die Dielektrikumschicht 312 hinein. Außerdem gibt es Aussparungen 364 und 366 links neben dem Fotolackbereich 352 bzw. rechts neben dem Fotolackbereich 356 in der Dielektrikumschicht 312. Erst dann werden die Fotolackbereiche 352 bis 358 wieder entfernt.

Bei einem anderen Ausführungsbeispiel mit verschieden dicken Titannitridschichten 314, 318 und 322 wird nur die Ätzung der Deckelektrode 322b mit Hilfe einer Endpunkterfassung durchgeführt. Bei beiden Prozessvarianten ist jedoch die Deckelektrode 322b dicker als die Grundelektrode 314a. Durch diese Maßnahme wird gewährleistet, dass nach dem vollständigen Strukturieren der Deckelektrode 322b die Grundelektrode 314a vollständig strukturiert ist. Insbesondere gibt es zwischen der Grundelektrode 314a und der Leitbahn 314b keine Materialreste der Titannitridschicht 314 mehr.

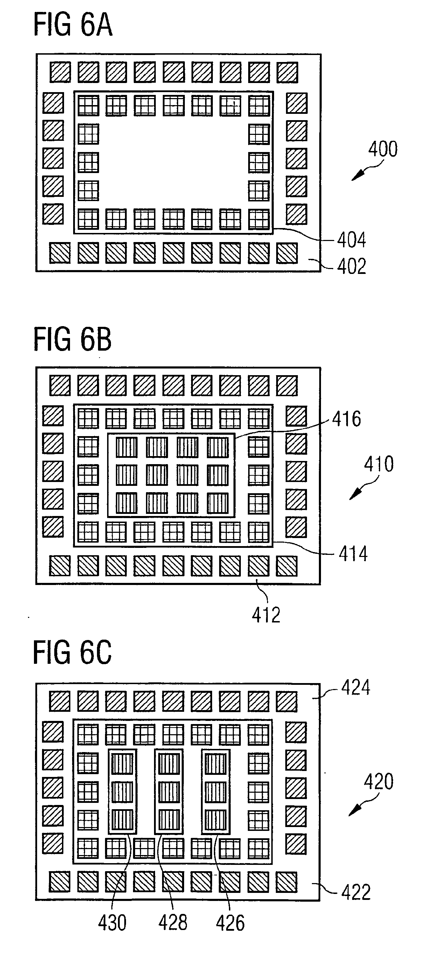

Figur 6A zeigt einen Referenzkondensator 400, der nur zwei Elektroden enthält, nämlich eine untere rechteckförmige Grundelektrode 402 und eine darüber angeordnete rechteckförmige Deckelektrode 404. Grundelektrode 402 und Deckelektrode 404 sind konzentrisch zueinander angeordnet. Die Grundelektrode 402 ist 150 µm lang und 100 µm breit. Die Deckelektrode 404 ist nur 145 µm lang und 95 µm breit. Damit ergibt sich eine für die Kapazität des Referenzkondensators 400 wirksame Fläche von 145 µm x 95 µm.

Figur 6B zeigt einen Kondensator 410, der eine Grundelektrode 412, eine Mittelelektrode 414 und eine Deckelektrode 416 enthält, die in der angegebenen Reihenfolge die folgenden Abmessungen haben 150 µm x 100 µm, 145 µm x 95 µm und 140 µm x 90 µm. Damit ergibt sich eine für die Kapazität des Kondensators 410 wirksame Fläche von 145 µm x 95 µm + 140 µm x 90 µm, d.h. von insgesamt 26375 µm². Dies entspricht einer Steigerung der Gesamtkapazität im Vergleich zum Kondensator 400 um über 90 %. Bei gleichbleibender Kapazität lässt sich somit die erforderliche Fläche für den Kondensator 412 im Vergleich zu der für den Kondensator 400 erforderlichen Fläche fast halbieren. Die Vias sind in den Figuren 6A bis 6C übertrieben groß im Verhältnis zu den Elektroden dargestellt. Der Viadurchmesser beträgt bspw. nur 0,4 µm. Der Abstand zwischen den Rändern zweier benachbarter Vias betragt bspw. ebenfalls nur 0,4 µm.

Figur 6C zeigt einen Kondensator 420, der eine Grundelektrode 422 mit einer Länge von 150 µm und einer Breite von 100 µm enthält. Eine oberhalb der Grundelektrode 422 angeordnete Mittelelektrode 424 ist 145 µm lang und 95 µm breit. Oberhalb der Mittelelektrode 424 sind drei Deckelektroden 426 bis 430 nebeneinander in einer Ebene angeordnet, die parallel zu einer Waferoberfläche bzw. Chipoberfläche liegt. Die Deckelektroden 426 bis 430 sind jeweils 90 µm lang und 30 µm breit. Im Vergleich zum Kondensator 400 benötigt der Kondensator 420 die gleiche Fläche. Jedoch lassen sich die drei Deckelektroden 426 bis 430 wahlweise zu der Hauptkapazität zwischen Grundelektrode 422 und Mittelelektrode 424 hinzuschalten. Beispielsweise wird nur eine Deckelektrode hinzugeschaltet, z.B. die Deckelektrode 426. Jedoch lassen sich auch zwei oder alle drei Deckelektroden 426 bis 430 zu der Hauptkapazität hinzuschalten.

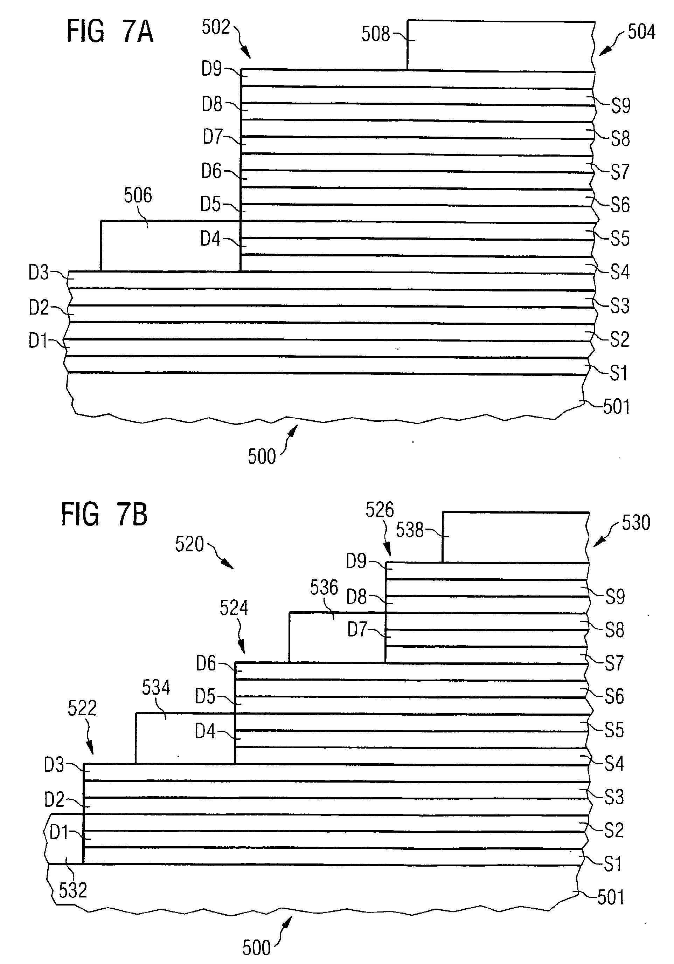

Das Grundkonzept der Erfindung lässt sich auch auf Kondensatoranordnungen erweitern, die mehr als drei Elektroden enthalten, beispielsweise auf eine Kondensatoranordnung 500 mit neun Elektroden S1 bis S9. Zwischen den Elektroden S1 bis S9 liegen in dieser Reihenfolge Dielektrikumschichten D1 bis D8. Auf der Elektrode S9 ist eine Dielektrikumschicht D9 angeordnet. Die Elektroden S1 bis S9 und die Dielektrikumschichten D1 bis D9 haben bei dem im Folgenden erläuterten Ausführungsbeispiel die gleiche Dicke von beispielsweise 45 nm. In den im Folgenden erläuterten Figuren 7A bis 7D wird nur die linke Seite eines zu strukturierenden Schichtstapels 502 dargestellt. Die rechte Seite des Schichtstapels wird auf die gleiche Weise wie die linke Seite strukturiert.

In einem ersten Lithografieverfahren werden die Elektrodenschichten für die Elektroden S4 bis S9 und die Dielektrikumschichten D4 bis D9 strukturiert. Als Ätzstopp dient die Dielektrikumschicht D3. Die Dielektrikumschicht D3 selbst sowie die Elektrodenschichten für die Elektroden S1 bis S3 sowie die Dielektrikumschichten D1 und D2 bleiben beim ersten Lithografieverfahren unstrukturiert. Auf dem so erzeugten Schichtstapel 502 wird eine Fotolackschicht 504 aufgebracht. Die Fotolackschicht 504 wird in einem zweiten lithografischen Verfahren strukturiert, wobei zwei Fotolackbereiche 506 und 508 erzeugt werden. Der Fotolackbereich 506 liegt auf einen Teil des freigelegten Bereiches der Dielektrikumschicht D3 auf. Linksseitig legt der Fotolackbereich 506 die linke Kante für die Strukturierung der Elektrodenschichten für die Elektroden S1 bis S3 fest. Rechtsseitig schließt der Fotolackbereich 506 an die Elektrodenschichten für die Elektroden S4 und S5 sowie an die dazwischenliegende Dielektrikumschicht D4 an. Der Fotolackbereich 508 liegt auf der Dielektrikumschicht D9 in einem zentralen Bereich, so dass ein Randbereich der Dielektrikumschicht D9 freibleibt. Durch die linke Kante des Fotolackbereiches 508 wird die Lage der Kanten eines Stapels aus den Elektrodenschichten für die Elektroden S7 bis S9 sowie der dazwischenliegenden Dielektrikumschichten D7 und D8 festgelegt.

Anschließend wird ein trocken-chemischer Ätzprozess durchgeführt, insbesondere ein chemisch-physikalischer Ätzprozess mit hoher Anisotropie. Es entsteht der in Figur 7B dargestellte Schichtstapel 520 mit dreifacher Abstufung, siehe Pfeile 522 bis 526.

Wie in Figur 7B dargestellt, wird im Rahmen eines dritten Lithografieverfahrens eine Fotolackschicht 530 aufgebracht, belichtet und strukturiert, so dass vier Fotolackbereiche 532 bis 538 entstehen. Der Fotolackbereich 532 liegt auf dem den Schichtstapel 520 tragenden Dielektrikum 501 auf, so dass das Dielektrikum 501 vor weiteren Strukturierungen geschützt ist. Der Fotolackbereich 534 liegt auf den rechten 2/3 des freiliegenden Bereiches der Dielektrikumschicht D3 im linken Teil des Schichtstapels 520 auf und grenzt mit seiner rechten Seite an die Elektrodenschichten für die Elektroden S4 und S5 sowie die dazwischenliegende Dielektrikumschicht D4 an. Die linke Seite des Fotolackbereiches 534 legt die Lage der Kanten der Elektrodenschichten für die Elektroden S2 und S3 bei der nächsten Strukturierung fest.

Der Fotolackbereich 536 liegt auf der Dielektrikumschicht D6 auf. Der Fotolackbereich 536 bedeckt die rechten 2/3 des freiliegenden Bereiches der Dielektrikumschicht D6 auf der linken Seite des Schichtstapels 520. Die linke Kante des Fotolackbereiches 536 legt die Lage der Kanten der Elektrodenschichten für die Elektroden S5 und S6 nach dem nächsten Strukturierungsschritt fest. Die rechte Kante des Fotolackbereiches 536 grenzt an die Elektrodenschichten für die Elektroden S5 und S8 sowie an die dazwischenliegende Dielektrikumschicht D7 an.

Der Fotolackbereich 538 liegt in einem zentralen Teil der Dielektrikumschicht D9. Die linke Kante des Fotolackbereiches 538 legt die Lage der linken Kanten der Elektrodenschichten für die Elektroden S8 und S9 sowie der dazwischenliegenden Dielektrikumschicht D8 nach der nächsten Strukturierung fest.

Bei der nächsten Strukturierung mit Hilfe der Fotolackbereiche 532 bis 538 wird mit Hilfe eines chemisch-physikalischen Ätzverfahrens gerichtet geätzt. Als Stoppschicht dient eine Endpunkterfassung des Materials der dielektrischen Schicht D1, D4 bzw. D7, die alle im Wesentlichen gleichzeitig erreicht werden.

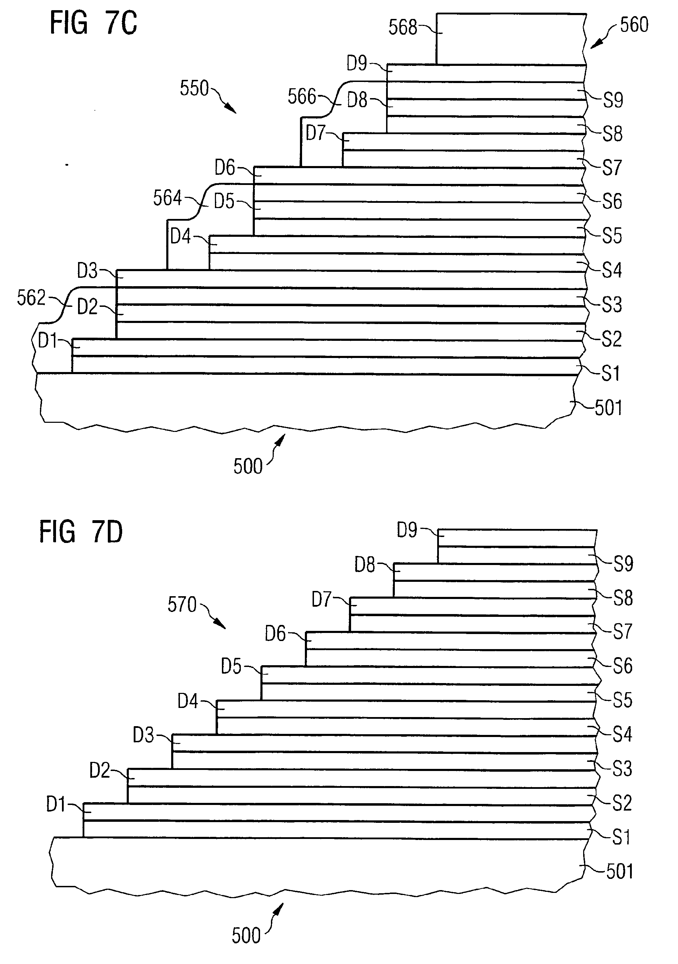

Figur 7C zeigt einen Schichtstapel 550, wie er nach dieser Ätzung auf der Schicht 501 vorhanden ist. In einem vierten Lithografieverfahren wird eine Fotolackschicht 560 auf den Schichtstapel 550 aufgebracht, belichtet und entwickelt, wobei Fotolackbereiche 562 bis 568 entstehen. Der Fotolackbereich 562 bedeckt die Dielektrikumschicht 501 und den freigelegten Bereich der Dielektrikumschicht D1. Der Fotolackbereich 564 bedeckt etwa die Hälfte des freiliegenden Bereiches der Dielektrikumschicht D3 auf der linken Seite des Schichtstapels 550 sowie den freiliegenden Teil der Dielektrikumschicht D4. Der Fotolackbereich 566 bedeckt die rechte Hälfte des freiliegenden Bereiches der Dielektrikumschicht D6 auf der linken Seite des Schichtstapels 550 sowie den freiliegenden Teil der Dielektrikumschicht D7. Der Fotolackbereich 568 liegt in einem zentralen Bereich auf der Dielektrikumschicht D9. Ein linker Randbereich auf der Dielektrikumschicht D9 bleibt unbedeckt.

Figur 7D zeigt das Ergebnis nach dem nächsten Ätzschritt. Ein Schichtstapel 570 ist pyramidenförmig aufgebaut und hat Stufen gleicher Höhe und gleicher Breite. Aufgrund dieser Abstufung lassen sich die Elektroden S1 bis S9 auf einfache Art und Weise von oben kontaktieren. Aufgrund der Abstufung gibt es auch keine Durchätzungen von Dielektrikumschichten D1 bis D9 unmittelbar am Rand zweier fluchtend zueinander angeordneter Elektroden S1 bis S9. Die Spannungsfestigkeit des Kondensators 500 ist deshalb sehr hoch.

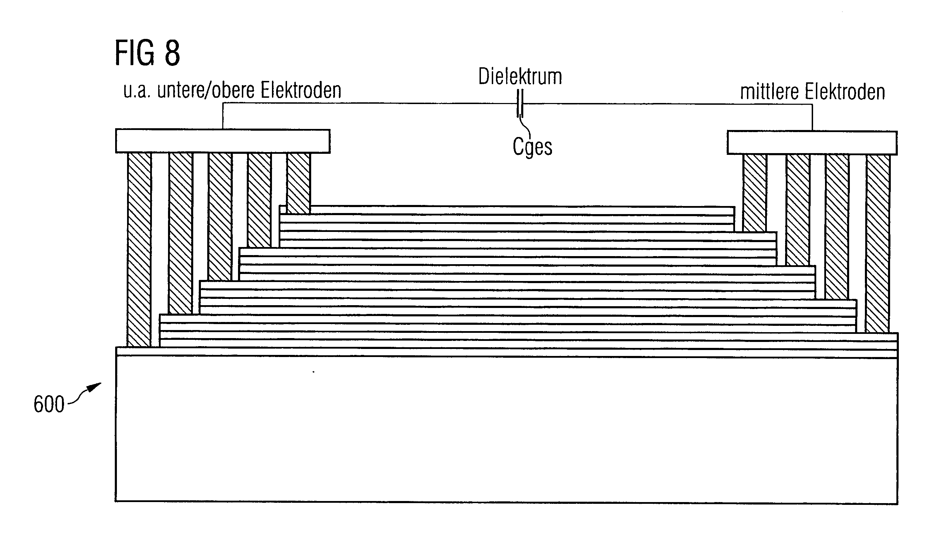

Figur 8 zeigt eine Kondensatoranordnung 600, die ebenfalls neun Elektroden enthält. Die Kondensatoranordnung 600 ist jedoch asymmetrisch so strukturiert, dass an den Stufen der linken Seite nur Elektroden S1, S3, S5, S7 und S9 kontaktiert werden können, d.h. nur jede zweite Elektrode. Auf der rechten Seite der Kondensatoranordnung 600 können dagegen die Elektroden S2, S4, S6 und S8 kontaktiert werden. Die Verfahrensschritte zum Herstellen der Kondensatoranordnung 600 sind ähnlich wie bei der Herstellung der Kondensatoranordnung 500.

Auch bei der Belichtung von Resist auf verschiedenen Stufen sehr großer Schichtstapel treten keine Probleme auf, wenn innerhalb der Grenzen der Fokustiefe gearbeitet wird. Beispielsweise beträgt die Fokustiefe 1 µm.

Die untere Elektrode der Kondensatoranordnung liegt bei einem anderen Ausführungsbeispiel oberhalb der unteren Metallisierungslage bezogen auf die beiden Metallisierungslagen, zwischen denen die Kondensatoranordnung angeordnet ist.

Bei einem nächsten Ausführungsbeispiel ist die untere Elektrode der Kondensatoranordnung vor Beginn schon in der Metallisierungslage ausgebildet, z.B. durch ein Damascene-Verfahren mit anschließendem Polierschritt. Im Rahmen des erläuterten Verfahrens werden dann die anderen Elektroden der Kondensatoranordnung hergestellt.

Die untere Elektrode der Kondensatoranordnung wird bei alternativen Ausführungsbeispielen über mindestens eine tiefer als diese Elektrode liegende Metallisierungslage angeschlossen.

Figur 9 zeigt eine Kondensatoranordnung 700, die oberhalb eines nicht dargestellten Halbleitersubstrats vier Metallisierungslagen Me1 bis Me4 enthält. Jede Metallisierungslage Me1 bis Me4 enthält eine Vielzahl von Leitbahnen aus einer Aluminiumlegierung mit einem Zusatz an Kupfer von weniger als 2 %. In Figur 9 sind jedoch nur die Leitbahnen der Metallisierungslagen Me1 bis Me4 dargestellt, die zur Kondensatoranordnung 700 gehören. Leitbahnen zum Anschluss von aktiven Bauelementen im Halbleitersubstrat sind also nicht dargestellt.

Die Metallisierungslagen Me1 bis Me4 sind in dieser Reihenfolge durch Zwischenlagen ILD1 bis ILD3 aus beispielsweise Siliziumdioxid voneinander elektrisch isoliert. Beispielsweise haben die Metallisierungslagen Me1 bis Me4 jeweils eine Dicke von 500 nm. Die Abstände benachbarter Metallisierungslagen Me1 bis Me4 liegen beispielsweise bei jeweils 800 nm.

Zum Herstellen der Kondensatoranordnung 700 werden bisher übliche Schichtabscheidungs-, Lithografie- und Strukturierungsverfahren eingesetzt, so dass diese hier nicht näher erläutert werden. Eine untere Elektrode 710 liegt in der Metallisierungslage Me1. Zwischen der Elektrode 710 und einer darüber liegenden Teilelektrode 712 liegt ein Dielektrikum 714. Die Teilelektrode 712 wird durch eine 45 nm dicke Titannitridschicht gebildet. Das Dielektrikum 714 ist eine 45 nm dicke Siliziumnitridschicht. Im Ausführungsbeispiel haben die Elektroden der Kondensatoranordnung 700 eine rechteckförmige Grundfläche, wobei eine Länge L in Längsrichtung der Rechtecke liegt. Die Länge L der Teilelektrode 712 beträgt beispielsweise 150 µm.

Die untere Elektrode 710 und das Dielektrikum 714 ragen über die Teilelektrode 712 hinaus. Das Dielektrikum 714 diente bei der Strukturierung der Teilelektrode 712 als Ätzstopp und wurde nur leicht angeätzt, so dass die Darstellung in der Figur 9 übertrieben ist. Auf der linken Seite erstreckt sich die untere Elektrode 710 weiter über die Teilelektrode 712 hinaus als auf der rechten Seite. Dadurch entsteht eine Anschlussfläche für einen Kontaktabschnitt Via1, der zwischen einer Leitbahn 718 der Metallisierungslage Me2 und der Elektrode 710 liegt. Der Kontaktabschnitt Via1 ist Teil einer Reihe von Kontaktabschnitten zwischen einer Leitbahn 718 in der Metallisierungsebene Me2 und der Grundelektrode 710.

Eine mit der Teilelektrode 712 über Kontaktabschnitte Via2 und Via3 verbundene Teilelektrode 720 liegt ebenfalls in der Metallisierungslage Me2. Die Kontaktabschnitte Via2 und Via3 sind Bestandteil zweier Viareihen zwischen den Teilelektroden 712 und 720. Die Teilelektroden 712 und 720 bilden eine Mittelelektrode der Kondensatoranordnung 700.

Der Teilelektrode 720 benachbart liegt in der Zwischenlage ILD2 eine Teilelektrode 722, die von der Teilelektrode 720 durch ein Dielektrikum 724 getrennt ist. Die Teilelektrode 722 besteht aus einer 45 nm dicken Titannitridschicht. Das Dielektrikum 724 besteht wiederum aus einer 45 nm dicken Siliziumnitridschicht. Auch die Teilelektrode 722 hat die Länge L. Die Teilelektrode 720 und das Dielektrikum 724 ragen rechts und links über die Teilelektrode 722 hinaus. Auch das Dielektrikum 724 diente als Ätzstopp beim Erzeugen der Teilelektrode 722 und wurde nur leicht angegriffen. Durch diese Maßnahmen wird das Dielektrikum 724 am empfindlichen Randbereich der Elektrode 722 nicht geschädigt.

Auf der rechten Seite ragt die Teilelektrode 720 stärker über die Teilelektrode 722 hinaus als auf der linken Seite, so dass eine Anschlussfläche für einen Kontaktabschnitt Via4 entsteht, der sich zwischen der Teilelektrode 720 und einer Leitbahn 728 in der Metallisierungslage Me3 erstreckt. Auch der Kontaktabschnitt Via4 ist Teil einer Reihe von Kontaktabschnitten zwischen der Leitbahn 728 und der Teilelektrode 720.

In der Metallisierungslage Me3 liegt außerdem eine Teilelektrode 730, die gemeinsam mit der Teilelektrode 722 die zweite Mittelelektrode der Kondensatoranordnung 700 bildet. Die Teilelektroden 722 und 730 sind über zwei Via-Reihen miteinander verbunden, von denen in Figur 9 zwei Kontaktabschnitte Via5 und Via6 dargestellt sind. Die Teilelektrode 730 ist von der Leitbahn 728 durch Teile der Zwischenlage ILD3 getrennt, siehe Zwischenraum 731. Die obere Mittelelektrode aus den Teilelektroden 722 und 730 ist mit der unteren Elektrode 710 elektrisch über zwei übereinander liegende Reihen von Kontaktabschnitten verbunden. Die obere Reihe führt von der Teilelektrode 730 zur Leitbahn 718. In Figur 9 ist ein Kontaktabschnitt Via7 dieser Reihe von Kontaktabschnitten dargestellt. Zur unteren Reihe gehört der Kontaktabschnitt Via1.

Schließlich enthält die Kondensatoranordnung 700 noch eine obere Elektrode 732, die von der Teilelektrode 730 durch ein Dielektrikum 734 getrennt ist. Die Teilelektrode 732 besteht ebenfalls aus Titannitrid und hat eine Dicke von 45 nm. Das Dielektrikum 734 besteht aus Siliziumnitrid und hat eine Dicke von 45 nm. Beim Strukturieren der oberen Elektrode 732 wurde das Dielektrikum 734 als Ätzstopp verwendet und nur gering angeätzt, vgl. übertriebene Darstellung in Figur 9. Die Teilelektrode 730 ragt über die obere Elektrode 732 links und rechts gemeinsam mit dem Dielektrikum 734 hinaus. Am linken Rand ragt die Teilelektrode 730 stärker über die obere Elektrode 732 hinaus als am rechten Rand, so dass eine Anschlussmöglichkeit für diejenige Reihe von Kontaktabschnitten entsteht, zu der auch der Kontaktabschnitt Via7 gehört.

Die obere Elektrode 732 hat ebenfalls die Länge L. Alle Elektroden 732, 722 und 712 in Zwischenlagen ILD3, ILD2 bzw. ILD1 sind fluchtend zueinander übereinander ausgerichtet, siehe gestrichelte Linie 736 und 738, und haben gleiche Umrisse.

Die obere Elektrode 732 ist über zwei Reihen von Kontaktabschnitten mit einer Leitbahn 740 verbunden, die in der Metallisierungslage Me4 liegt. In Figur 9 sind zwei Kontaktabschnitte Via8 und Via9 dieser beiden Reihen dargestellt. Vom rechten Teil der Leitbahn 740 aus erstreckt sich eine Reihe von Kontaktabschnitten zur Leitbahn 728, siehe Kontaktabschnitt Via10. Somit wird die obere Elektrode 732 mit der unteren Mittelelektrode, d.h. den Teilelektroden 712 und 720 der Kondensatoranordnung 700 elektrisch leitend verbunden.

Die linken Teile der Leitbahn 740 und der Teilelektrode 730 dienen zum Anschluss der Kondensatoranordnung, so dass zwischen diesen Teilen eine Gesamtkapazität Cges entsteht.

In Figur 9 ist außerdem eine Schaltskizze 750 dargestellt, aus der die Verschaltung von Kapazitäten C1, C2 und C3 der Kondensatoranordnung 700 zu entnehmen ist. Die Kapazität C1 wird durch die untere Elektrode 710 und durch die Teilelektrode 712 gebildet. Die Kapazität C2 wird durch die Teilelektrode 720 und die Teilelektrode 722 gebildet. Die Kapazität C3 wird durch die Teilelektrode 730 und durch die obere Elektrode 732 gebildet. Die Kapazitäten C1 bis C3 sind zueinander elektrisch parallel geschaltet, was durch die verzahnte Anordnung der Elektroden in der Kondensatoranordnung 700 erreicht wird.

Bei einem anderen Ausführungsbeispiel enthält die Kondensatoranordnung 700 nur zwei MIM-Kondensatoren, so dass beispielsweise nur die Metallisierungslagen Me1 bis Me3 in die Kondensatoranordnung einbezogen werden. In diesem Fall wird die Flächenkapazität nicht verdreifacht, sondern nur verdoppelt, siehe gestrichelte Linie 752 in der Schaltskizze 750. In diesem Fall enthält die Kondensatoranordnung nämlich nur die Kapazitäten C1 und C2.

Bei einem weiteren Ausführungsbeispiel erstreckt sich die Kondensatoranordnung über mehr als vier Metallisierungsebenen. Auf diese Weise lässt sich eine Vervierfachung, eine Verfünffachung usw. der Flächenkapazität erreichen. Beispielsweise wäre die Metallisierungslage Me4 so zu strukturieren, wie die Metallisierungslage Me2. Oberhalb der Metallisierungslage Me4 gäbe es eine Metallisierungslage Me5, die wie die Metallisierungslage Me3 strukturiert wäre. Auf der linken Seite der Kondensatoranordnung 700 würden Kontaktabschnitte Via1, Via7 usw. übereinanderliegen, mit denen die untere Elektrode 710, die zweite Mittelelektrode, die vierte Mittelelektrode usw. verbunden sind. Auf der rechten Seite der Kondensatoranordnung liegen Kontaktabschnitte Via4, Via10 usw., mit denen die erste Mittelelektrode, die dritte Mittelelektrode usw. und die Deckelektrode miteinander verbunden sind.

Somit wiederholen sich die Strukturen der Elektroden in der Kondensatoranordnung. Dies führt dazu, dass gleiche Teilabschnitte von Masken für die Lithografie benutzt werden können. Insbesondere sind alle Elektroden 712, 722, 732 in Zwischenlagen ILD1 bis ILD3 gemäß dem gleichen Layout gefertigt. Figur 10 zeigt eine Kondensatoranordnung 800, die sich über drei Metallisierungslagen 802, 804 und 806 erstreckt. Die Metallisierungslage 802 liegt auf einer Zwischenlage 810, die beispielsweise aus Siliziumdioxid besteht. Zwischen den Metallisierungslagen 802 und 804 liegt eine Zwischenlage 812, die ebenfalls aus Siliziumdioxid besteht. Zwischen den Metallisierungslagen 804 und 806 liegt ebenfalls eine Zwischenlage 814 aus Siliziumdioxid. Die Kondensatoranordnung 800 enthält ausgehend von einer unteren Elektrode 820 fortschreitend zu substratferneren Elektroden in der folgenden Reihenfolge:
- eine Elektrode 822,
- eine Elektrode 824,
- eine Teilelektrode 826,
- eine Teilelektrode 828,
- eine Elektrode 830,
- eine Elektrode 832, und
- obere Elektrode 834.

Die untere Elektrode 820 und die Teilelektrode 828 liegen in der Metallisierungslage 802 bzw. 804 und bestehen im Ausführungsbeispiel aus einer Aluminiumlegierung mit weniger als 5 % Zusätzen an Kupfer und/oder Silizium. Im Ausführungsbeispiel sind die Metallisierungslagen 802 bis 806 beispielsweise 500 nm dick. Der Abstand zwischen benachbarten Metallisierungslagen beträgt im Ausführungsbeispiel 750 nm.

Die Elektroden 822, 824, die Teilelektrode 826, die Elektroden 830, 832 sowie die Teilelektrode 834 bestehen aus Titannitrid mit jeweils einer Dicke von 45 nm.

Zwischen den Elektroden 820 bis 834 liegen in dieser Reihenfolge Dielektrika 840 bis 852. Auch auf der oberen Elektrode 824 liegt ein Dielektrikum 854. Die Dielektrika 840 bis 854 bestehen aus Siliziumnitrid und haben eine Schichtdicke von 45 nm im Ausführungsbeispiel. Das Dielektrikum 846 liegt auf der Teilelektrode 826.

Über vier linksseitige Kontaktabschnitte Via11 bis Via14 sowie über eine Leitbahn 860 in der Metallisierungslage 804 und eine Leitbahn 862 in der Metallisierungslage 806 sind die untere Elektrode 820, die Elektrode 824, die Elektrode 830 und die obere Elektrode 834 miteinander elektrisch verbunden, d.h. jede zweite Elektrode der Kondensatoranordnung 800 beginnend von der unteren Elektrode 820. Drei rechtsseitige Kontaktabschnitte Via15 bis Via17 und eine Leitbahn 864 in der Metallisierungslage 804 verbinden die Elektroden 822, eine aus den Teilelektroden 826 und 828 bestehende Elektrode und die Elektrode 832 elektrisch miteinander, d.h. jede zweite Elektrode der Kondensatoranordnung beginnend mit der der unteren Elektrode 820 benachbarten Elektrode 822. Die Kontaktabschnitte Via11 bis Via17 sind jeweils Bestandteil einer Reihe von Kontaktabschnitten, die sich jeweils in die Blattebene hinein bzw. aus der Blattebene hinaus erstrecken.

Die Elektrode 822, das Dielektrikum 842, die Elektrode 824, das Dielektrikum 844, die Teilelektrode 826 und das Dielektrikum 846 bilden einen Schichtstapel 870. Die Schichten des Schichtstapels 870 werden nacheinander abgeschieden und anschließend mit Hilfe von nur zwei Lithografieverfahren strukturiert. Mit einem ersten Lithografieverfahren werden die Elektrode 824 und das Dielektrikum 844 strukturiert sowie die Teilelektrode 826 und das Dielektrikum 846 vorstrukturiert. Mit dem zweiten Lithografieverfahren werden die Elektrode 822 und das Dielektrikum 842 strukturiert. Außerdem wird mit Hilfe des zweiten Lithografieverfahrens die Teilelektrode 826 und das Dielektrikum 846 strukturiert. Ein drittes Lithografieverfahren wird benötigt, um die Elektrode 828 und damit auch das Dielektrikum 848 zu strukturieren.

Danach wird die Zwischenlage 812 erzeugt und planarisiert. Anschließend werden Vialöcher für die Kontaktabschnitte Via11, Via12 und Via15 sowie für Kontaktabschnitte Via18 und Via19 geätzt und gefüllt. Die Kontaktabschnitte Via18 und Via19 führen zur Teilelektrode 826 und sind Bestandteil von zwei zueinander parallelen Reihen aus Kontaktabschnitten.

Auf die Zwischenlage 812 wird dann eine Aluminiumschicht und ein Dielektrikum 848 aufgebracht. Nach dem Abscheiden des Dielektrikums 848 wird ein Schichtstapel 872 erzeugt, der Schichten für die Elektrode 830, für das Dielektrikum 850, für die Elektrode 832, für das Dielektrikum 852, für die obere Elektrode 834 und für das Dielektrikum 854 enthält. Auch der Schichtstapel 872 wird nach dem gleichen Verfahren strukturiert wie der Schichtstapel 870. Ein weiteres Lithografieverfahren wird benötigt, um die Elektrode 828 und damit auch das Dielektrikum 848 zu strukturieren.

Anschließend wird das Material der Zwischenlage 814 abgeschieden. Nach einem Planarisierungsschritt werden Kontaktlöcher für die Kontaktabschnitte Via13, Via14, Via16 und Via17 sowie für zwei Kontaktabschnitte Via20 und Via21 erzeugt. Die Kontaktabschnitte Via20 und Via21 liegen in der fertiggestellten Kondensatoranordnung 800 zwischen der Leitbahn 862 und der oberen Elektrode 854. Auch die Kontaktabschnitte Via20 und Via21 sind Bestandteile von zwei Reihen von Kontaktabschnitten zwischen der Leitbahn 862 und der oberen Elektrode 854.

Eine Schaltskizze 880 zeigt die Verschaltung von Kapazitäten C1a bis C6a der Schaltungsanordnung 800. Die Flächenkapazität wird durch die Anordnung der Kapazitäten C1a bis C6a versechsfacht. Auch bei der Kondensatoranordnung 800 fluchten die Teilelektrode 826 und die Teilelektrode 834, d.h. die oberen Elektroden des Schichtstapels 870 bzw. 872, siehe gestrichelte Linie 882 und 884.

Bei einem anderen Ausführungsbeispiel sind die Elektroden 824 und das Dielektrikum 844 nicht im Schichtstapel 870 vorhanden, siehe geschweifte Klammer 881a. Auch die Elektrode 830 und das Dielektrikum 850 ist nicht im Schichtstapel 872 enthalten, siehe geschweifte Klammer 881b. Die Kontaktabschnitte Via12 und Via14 entfallen. Die Leitbahn 860 ist mit der Teilelektrode 828 elektrisch leitend verbunden. Der rechte Teil der Teilelektrode 828 ist als eigene Leitbahn ausgeführt und mit den Kontaktabschnitten Via15 und Via17 verbunden. Der Kontaktabschnitt Via15 dient zum Anschluss der nach rechts verlängerten Elektrode 824.

Bei einem weiteren Ausführungsbeispiel werden bei den Kondensatoranordnungen 700 und 800 an Stelle von Aluminium-Metallisierungslagen Kupfer-Metallisierungslagen verwendet. Zur Herstellung einer Metallisierungslage wird in diesem Fall ein sogenanntes Damascene-Verfahren eingesetzt, das jeweils mit einem chemisch-mechanischen Polierschritt endet. Bei der Verwendung von Kupfer wird an Stelle des Titannitrids Tantalnitrid eingesetzt.

Bei anderen Ausführungsbeispielen mit Aluminium- oder Kupferelektroden werden zwischen den Elektroden und dem Dielektrikum TiN- oder TaN Liner als Vermittler verwendet, um z.B. die Rauhigkeit zu reduzieren oder die Haftung zu erhöhen.

Die erläuterten Kondensatoranordnungen werden in Designbibliotheken als Standardbauteile für den Chipdesigner hinterlegt. Damit kann der Designer zwischen Einfach-MIM-Kondensatoren, Dual-Kondensatoren, Tripel-Kondensatoren usw. oder zwischen Kondensatoranordnungen wählen, die sich über mehrere Metallisierungslagen erstrecken und ihrerseits mehrere Einfach-, Dual- oder Tripel-MIM-Kondensatoren usw. oder eine Kombination aus diesen Kondensatoren enthalten.

Durch die Verfahren zur Herstellung der an Hand der Figuren 9 und 10 erläuterten Kondensatoranordnungen wird unter anderem erreicht:
- mehrfache Integration von MIM-Kondensatoren in einem Metallisierungs-BEOL (Back End of Line),
- gegebenenfalls Verwendung von einer Teilmaske zur Strukturierung aller MIM-Kondensatoren,
- Erhöhung der erreichbaren Flächenkapazität eines Standard-MIM-Kondensators um ein Vielfaches, und
- mit den vorgeschlagenen Anordnungen können Kapazitäten mit hoher Güte und hoher Linearität hergestellt werden.

Insbesondere werden auch bei den Kondensatoranordnungen 700 und 800 Maßnahmen getroffen, um Schäden am Rand des Dielektrikums zu vermeiden, beispielsweise das Verwenden eines Überstandes und/oder der Kombination einer Trockenätzung und einer Nassätzung bzw. Nassreinigung.

Auch werden Sätze von Kondensatoranordnungen 700 bzw. 800 gefertigt, bei denen bestimmte Kontaktabschnitte weggelassen werden, um die Gesamtkapazität zu verringern. Beispielsweise wird bei der Kondensatoranordnung 800 der Kontaktabschnitt Via11 weggelassen, so dass die Kapazität C1a nicht mehr zur Gesamtkapazität C beiträgt.

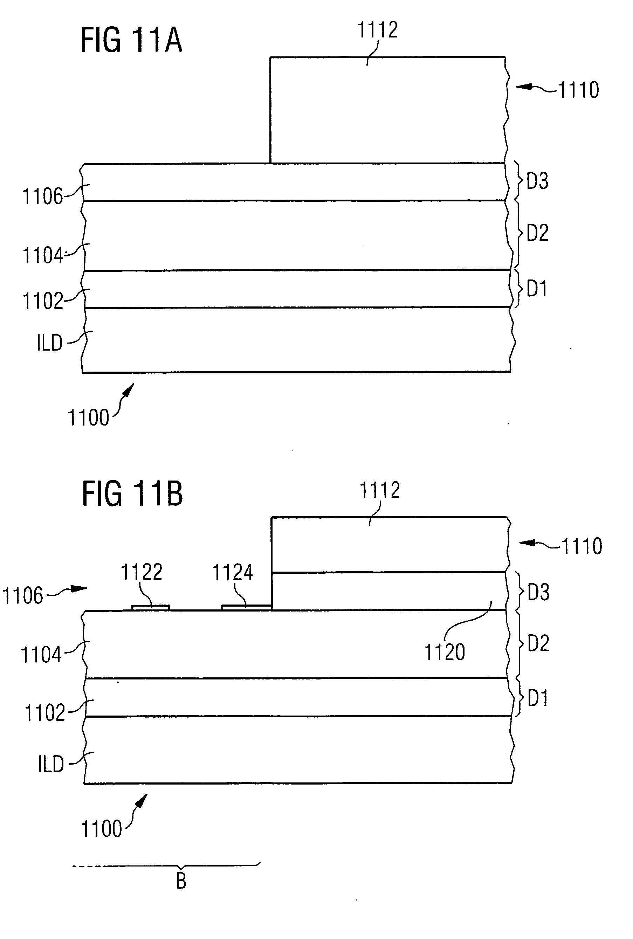

Figur 11A zeigt eine integrierte Schaltungsanordnung 1100, die eine nicht dargestellte Halbleiterscheibe enthält, bspw. eine Siliziumscheibe (Wafer). In bzw. auf der Halbleiterscheibe befinden sich aktive Bereiche einer Vielzahl von elektronischen Bauelementen, z.B. von Transistoren.

Nach der Fertigung der aktiven elektronischen Bauelemente wird gegebenenfalls nach dem Abscheiden weiterer Schichten eine dielektrische Schicht ILD aufgebracht, die im Ausführungsbeispiel zwischen zwei Metallisierungslagen liegt. Die obere dieser beiden Metallisierungslagen wird in einer Titannitridschicht 1102 gebildet, die auf die dielektrische Schicht ILD aufgebracht worden ist. Die Titannitridschicht 1102 hat im Ausführungsbeispiel eine Dicke D1 von 45 nm.

Auf die Titannitridschicht 1102 wird eine Siliziumnitridschicht 1104 als dielektrische Schicht mit einer Dicke D2 von bspw. 100 nm aufgebracht. Anschließend wird auf die Siliziumnitridschicht 1104 eine weitere Titannitridschicht 1106 aufgebracht, die eine Dicke D3 von 45 nm hat.

Nach dem Erzeugen der oberen Titannitridschicht 1106 wird eine Fotolackschicht 1110 aufgebracht. Anschließend wird die Fotolackschicht 1110 mittels einer Maske belichtet. Nach dem Belichten wird die Fotolackschicht 1110 entwickelt, wobei ein Fotolackbereich 1112 entsteht.

Wie in Figur 11B dargestellt, wird anschließend ein Plasmaätzprozess durchgeführt, bei dem die Titannitridschicht 1106 strukturiert wird. Es entsteht unterhalb des Fotolackbereichs 1112 eine Deckelektrode 1120 der zu erzeugenden Kondensatoranordnung. Die Dicke der Deckelektrode 1120 ist gleich der Dicke D3, d.h. 45 nm. In dem nicht vom Fotolackbereich 1112 bedeckten Bereich wird die Titannitridschicht dagegen fast vollständig entfernt. Es gibt nur wenige Reste 1122 und 1124 der Titannitridschicht 1106 in einem nicht vom Fotolack bzw. Resist bedeckten Bereich B. Die Reste 1122 bzw. 1124 haben bspw. nur eine Dicke von 1 nm oder 2nm.

Die Titannitridschicht 1106 wird beim Plasmaätzen zeitgesteuert so geätzt, dass die Dicke der dielektrischen Schicht 1104 im wesentlichen unverändert bleibt. Der durch die Trockenätzung verursachte Ätzabtrag an der dielektrischen Schicht 1104 liegt unter 1 nm. Ziel ist eine Trockenätzung der Titannitridschicht 1106 ohne Überätzung bzw. eine Überätzung von 0 s (Sekunden). Das bedeutet, dass nur Material der Titannitridschicht 1106 abgetragen werden soll aber kein Material der dielektrischen Schicht 1104. Beim Berechnen der Ätzzeit muss deshalb von den dünnsten Stellen der Titannitridschicht 1106 ausgegangen werden.

Nach dem Durchführen des Trockenätzprozesses werden die verbliebenen Reste der Fotolackschicht 1110 wieder entfernt. Insbesondere wird der Fotolackbereich 1112 entfernt.

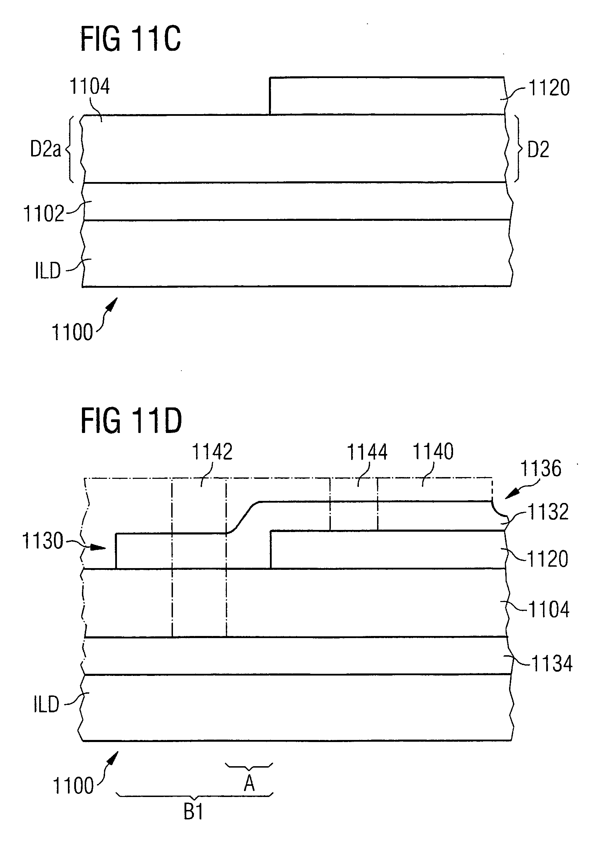

Wie in Figur 11C dargestellt, wird anschließend ein Nassreinigungsschritt durchgeführt, bei dem die Reste 1122 und 1124 entfernt werden. Die Nassreinigung ist hochselektiv zu dem Siliziumnitrid der Siliziumnitridschicht 1104, so dass sich die Dicke der Siliziumnitridschicht 1104 nur geringfügig auf eine Dicke D2a verringert.

Als nass-chemisches Ätzbad wird eine Mischung aus einer 35%-igen wässrigen Wasserstoffperoxid-Lösung und einer etwa 28%-igen wässrigen Ammoniak-Lösung verwendet. Das Volumenverhältnis von Wasserstoffperoxid-Lösung zu Ammoniak-Lösung beträgt 20:1. Die nass-chemische Ätzung wird bei Raumtemperatur ausgeführt.

Eine solche Ätzung von Titannitrid ist hochselektiv zum Siliziumnitrid. Während der nasschemischen Reinigung kommt es zu einer leichten Randanätzung der Elektrode 1120, die jedoch nicht störend ist, wenn die Elektrode 1120 zuvor etwas größer strukturiert worden ist, als eigentlich erforderlich.

Wie in Figur 11D dargestellt, wird anschließend eine Fotolackschicht 1130 abgeschieden, gemäß einer vorgegebenen Maske belichtet und entwickelt, wobei ein Fotolackbereich 1132 oberhalb eines Teilbereiches B1 eines nicht von der Deckelektrode 1120 bedeckten Bereiches der Siliziumnitridschicht 1104 und oberhalb der Deckelektrode 1120 entsteht. In einem folgenden Trockenätzprozess werden die Siliziumnitridschicht 1104 und die darunter liegende Titannitridschicht 1102 gemäß dem Fotolackbereich 1132 strukturiert. Dabei entsteht ein Bodenelektrode 1134, die gemeinsam mit dem verbleibenden Dielektrikum der dielektrischen Schicht 1104 und der Deckelektrode 1120 eine Kondensatoranordnung 1136 bildet. Gleichzeitig werden in der Titannitridschicht 1102 Leitbahnen erzeugt, die zum Anschluss der aktiven Bauelemente dienen.

Auf die Kondensatoranordnung 1136 wird nach dem entfernen der Reste der Fotolackschicht 1130 eine dielektrische Schicht 1140 aufgebracht, die bspw. aus Siliziumdioxid besteht und eine Dicke von mehreren hundert Nanometern hat. Die dielektrische Schicht 1140 wird planarisiert und bildet das Dielektrikum zur nächst höher liegenden Metallisierungslage, d.h. einer Metallisierungslage, die weiter vom Halbleitersubstrat entfernt ist als die aus der Titannitridschicht 1102 erzeugte Metallisierungslage.

Mit Hilfe eines weiteren Lithografieverfahrens werden anschließend Kontaktabschnittslöcher 1142 und 1144 für Kontaktabschnitt erzeugt, d.h. für sogenannte Vias. Dabei wird im Fall des Kontaktabschnittslochs 1142 durch die dielektrischen Schichten 1140 und 1104 hindurch bis zur Bodenelektrode 1134 und im Fall des Kontaktloches 1144 nur durch die dielektrische Schicht 1140 hindurch bis zur Deckelektrode 1120 geätzt.

Die Kontaktabschnittlöcher 1142 und 1144 werden danach ggf. unter Einbringung geeigneter Zwischenschichten mit einem elektrisch leitenden Material gefüllt, bspw. mit Wolfram. Der rechte Rand des Kontaktloches 1142 hat einen Abstand A vom linken Rand der Deckelektrode 1120 von bspw. 400 nm.

Bei anderen Ausführungsbeispielen werden an Stelle der dielektrischen Schicht 1104 dielektrische Doppel- oder Mehrfachschichten verwendet. An Stelle der Titannitridschichten 1102 und 1106 werden ebenfalls Doppel- oder Mehrfachschichten aus elektrisch leitfähigen Materialien verwendet. Die erläuterten Verfahren an der Grenze zwischen dem oberen Schichtstapel aus elektrisch leitenden Schichten und einem Schichtstapel aus dielektrischen Schichten bleiben jedoch so, wie oben an Hand der Figuren 11A bis 11D erläutert.

Bei einem weiteren Ausführungsbeispiel ist die dielektrische Schicht 1104 nicht von einem Kontaktabschnitt durchdrungen, bspw. dann, wenn die Bodenelektrode in einer Metallisierungslage liegt und von unten angeschlossen ist. Dennoch stehen das Dielektrikum des Kondensators und die Bodenelektrode über die Deckelektrode hinaus, um eine Schädigung des Dielektrikums beim Strukturieren der dielektrischen Schicht und der Bodenelektrode in sensiblen Randbereichen der Deckelektrode zu vermeiden. Das überstehende Dielektrikum wird durch die oben dargelegte Vorgehensweise weder nennenswert angeätzt noch verbleiben Reste der zum Herstellen der Deckelektrode verwendeten Schicht auf dem Dielektrikum. Insbesondere gibt es keine Reste am Rand der Elektrode in Bereichen, wo die Deckelektrode durch das Trockenätzverfahren strukturiert worden ist.

Bei anderen Ausführungsbeispielen ist die untere Elektrode nur auf einer lateralen Seite des Kondensators kontaktiert. An der kontaktierten Seite durchdringt ein Via das Dielektrikum. An der anderen Seite ragen das Dielektrikum und die Bodenelektrode über die Deckelektrode hinaus ohne dass dort ein Via angebracht wird. Somit werden auch an dieser Seite Schäden des Dielektrikums am empfindlichen Elektrodenrandbereich vermieden.

Die an Hand der Figuren 11A bis 11D erläuterten Verfahren werden auch bei Kondensatoren eingesetzt, die mehrere dielektrische Schichten zwischen drei oder mehr als drei Elektroden enthalten, insbesondere bei Kondensatoranordnungen, die zwischen zwei Metallisierungslagen liegen oder sich über mehrere Metallisierungslagen erstrecken.

## Patentansprüche

1. Integrierte Schaltungsanordnung enthaltend eine Kondensatoranordnung (700, 800),
mit mindestens drei durch Zwischenlagen (ILD1 bis ILD3) voneinander getrennten Metallisierungslagen (Me1 bis Me4), die Leitbahnen (718, 728) zum Anschluss elektronischer Bauelemente enthalten,
mit elektrisch leitfähigen Kontaktabschnitten (Via1 bis Via10), die quer zu den Metallisierungslagen (Me1 bis Me4) liegen,
mit einer Kondensatoranordnung (700), die zu zwei ineinander greifenden Kondensatorplatten über Kontaktabschnitte (Via1 bis Via10) verschaltete Elektroden (710, 712, 732) enthält,
**dadurch gekennzeichnet, dass** die Elektroden (710, 712, 732) der Kondensatoranordnung (700) in mindestens zwei Zwischenlagen (ILD1 bis ILD3) angeordnet sind,
dass mindestens eine Elektrode der Kondensatoranordnung (700) eine in einer Metallisierungslage (Me2) liegende Teil-Elektrode (720) und eine in einer Zwischenlage (ILD1) liegende Teil-Elektrode (712) enthält, wobei beide Teil-Elektroden (720, 712) über mindestens einen Kontaktabschnitt (Via2, Via3) oder über mehrere Kontaktabschnitte miteinander elektrisch verbunden sind, und
dass die in der Metallisierungslage (Me1 bis Me4) liegende Teileelektrode (720) an voneinander abgewandten Flächen kontaktiert ist.

2. Schaltungsanordnung nach Anspruch 1, **dadurch gekennzeichnet, dass** mindestens eine Elektrode (710) oder eine Teil-Elektrode (720) der Kondensatoranordnung (700) in einer Metallisierungslage (Me1 Me2) liegt.

3. Schaltungsanordnung nach Anspruch 1 oder 2, **dadurch gekennzeichnet, dass** Elektroden (712, 722, 732) der Kondensatoranordnung (700) in mindestens drei Zwischenlagen (ILD1 bis ILD3) oder in mehr als drei Zwischenlagen (ILD1 bis ILD3) angeordnet sind.

4. Schaltungsanordnung nach einem der vorhergehenden Ansprüche, **gekennzeichnet durch** mindestens eine in einer Zwischenlage (ILD2) angeordnete Elektrode (722), die den gleichen Umriss wie eine andere in einer anderen Zwischenlage (ILD3) angeordnete Elektrode (732) hat.

5. Schaltungsanordnung nach Anspruch 4, **dadurch gekennzeichnet, dass** die Elektroden (722, 732) mit gleichem Umriss an ihren Rändern in Normalenrichtung zu einer die Kondensatoranordnung (700) tragenden Substratfläche fluchtend (736, 738) angeordnet sind, vorzugsweise entlang des gesamten Randes.

6. Schaltungsanordnung nach einem der Ansprüche 1 bis 5, **dadurch gekennzeichnet, dass** zwischen zwei Metallisierungslagen (802, 804) mindestens zwei Elektroden (822, 824) oder mindestens drei Elektroden (822 bis 826) der Kondensatoranordnung angeordnet sind.

7. Schaltungsanordnung nach einem der vorhergehenden Ansprüche, **dadurch gekennzeichnet, dass** mindestens drei in der Kondensatoranordnung (800) aufeinanderfolgende Elektroden (822 bis 826) mit einer Anzahl von Lithografieverfahren strukturiert worden sind, die kleiner als die Anzahl der aufeinander folgenden Elektroden (822 bis 826) ist.

8. Schaltungsanordnung nach einem der vorhergehenden Ansprüche, **dadurch gekennzeichnet, dass** jede Elektrode mit mehreren Kontaktabschnitten (Via1 bis Via10) angeschlossen ist,
und/oder dass die Kontaktfläche mindestens einer in einer Zwischenlage (ILD1 bis ILD3) liegenden Teil-Elektrode (722) mehr als 30 % oder mehr als 50 % der Grundrissfläche dieser Teil-Elektrode beträgt,
und/oder dass die Kontaktfläche zum Anschluss mindestens einer weiteren Elektrode, die keine Teil-Elektrode ist, gleich der Kontaktfläche der Teil-Elektrode ist.

9. Schaltungsanordnung nach einem der vorhergehenden Ansprüche, **dadurch gekennzeichnet, dass** die metallischen Abschnitte einer Metallisierungslage (Me1 bis Me4) aus Kupfer, aus Aluminium, aus einer Kupferlegierung mit mindestens 90 % Kupfer oder einer Aluminiumlegierung mit mindestens 90 % Aluminium bestehen,
und/oder dass die Metallisierungslagen (Me1 bis Me4) eine Dicke größer als 100 nm oder größer 150 nm haben,
und/oder dass die Elektroden in Zwischenlagen (ILD1 bis ILD3) aus einem Metall oder aus einer Metalllegierung bestehen oder ein Metall oder eine Metalllegierung enthalten, insbesondere ein Metallnitrid, vorzugsweise Titannitrid oder Tantalnitrid, und/oder dass mindestens eine Elektrode in einer Zwischenlage (ILD1 bis ILD3) eine Dicke kleiner als 100 nm oder kleiner als 60 nm hat,
und/oder dass die Elektroden in den Zwischenlagen (ILD1 bis ILD3) nur an einer Fläche kontaktiert sind,
und/oder dass die Zwischenlagen (ILD1 bis ILD3) aus einem Oxid bestehen oder ein Oxid enthalten, insbesondere Siliziumdioxid, oder ein Nitrid enthalten oder aus einem Nitrid bestehen, insbesondere aus Siliziumnitrid.

10. Kondensatoranordnungen (700),
mit mindestens zwei integrierten Kondensatoranordnungen (700), die bis auf geometrische Entwürfe zum Festlegen der Lage von Kontaktabschnitten (Via1 bis Via10) nach den gleichen geometrischen Entwürfen gefertigt worden sind,
wobei mindestens eine der beiden Kondensatoranordnungen (700) wie eine Kondensatoranordnung (700) nach einem der vorhergehenden Ansprüche aufgebaut ist,
und wobei mindestens ein Kontaktabschnitt (Via1 bis Via10) zum Anschluss einer Elektrode (710) in der einen Kondensatoranordnung (700) vorhanden ist und in der anderen Kondensatoranordnung nicht vorhanden ist, so dass mindestens eine Elektrode in der anderen Kondensatoranordnung nicht angeschlossen ist.

11. Kondensatoranordnungen (700) nach Anspruch 10, **dadurch gekennzeichnet, dass** die angeschlossene Elektrode (710) bezüglich der einen Kondensatoranordnung (700) die gleiche Lage wie die nicht angeschlossene Elektrode bezüglich der anderen Kondensatoranordnung hat.

## Claims

1. Integrated circuit arrangement which includes a capacitor arrangement (700, 800),
having at least three metallization layers (Me1 to Me4), which are separated from one another by interlayers (ILD1 to ILD3) and include interconnects (718, 728) for connection of electronic components, having electrically conductive contact sections (Via1 to Via10) which are located transversely with respect to the metallization layers (Me1 to Me4),
having a capacitor arrangement (700), which includes electrodes (710, 712, 732) which are connected up via contact sections (Via1 to Via10) to form two intermeshing capacitor plates, **characterized in that** the electrodes (710, 712, 732) of the capacitor arrangement (700) are arranged in at least two interlayers (ILD1 to ILD3),
**in that** at least one electrode of the capacitor arrangement (700) includes a partial electrode (720) which lies in a metallization layer (Me2) and a partial electrode (712) which lies in an interlayer (ILD1), the two partial electrodes (720, 712) being electrically connected to one another via at least one contact section (Via2, Via3) or via a plurality of contact sections, and
**in that** contact is made with the partial electrode (720) lying in the metallization layer (Me1 to Me4) on surfaces which face away from one another.

2. Circuit arrangement according to Claim 1, **characterized in that** at least one electrode (710) or a partial electrode (720) of the capacitor arrangement (700) lies in a metallization layer (Me1, Me2).

3. Circuit arrangement according to Claim 1 or 2, **characterized in that** electrodes (712, 722, 732) of the capacitor arrangement (700) are arranged in at least three interlayers (ILD1 to ILD3) or in more than three interlayers (ILD1 to ILD3).

4. Circuit arrangement according to one of the preceding claims, **characterized by** at least one electrode (722) which is arranged in an interlayer (ILD2) and has the same contour as another electrode (732) arranged in another interlayer (ILD3).

5. Circuit arrangement according to Claim 4, **characterized in that** the electrodes (722, 732) having the same contour at their edges are arranged flush (736, 738), preferably along the entire edge, perpendicular to a substrate surface which supports the capacitor arrangement (700).

6. Circuit arrangement according to one of Claims 1 to 5, **characterized in that** at least two electrodes (822, 824) or at least three electrodes (822 to 826) of the capacitor arrangement are arranged between two metallization layers (802, 804).

7. Circuit arrangement according to one of the preceding claims, **characterized in that** at least three successive electrodes (822 to 826) in the capacitor arrangement (800) have been patterned using a number of lithography methods which is smaller than the number of successive electrodes (822 to 826).

8. Circuit arrangement according to one of the preceding claims, **characterized in that** each electrode is connected by means of a plurality of contact sections (Via1 to Via10),
and/or **in that** the contact surface of at least one partial electrode (722) lying in an interlayer (ILD1 to ILD3) forms more than 30% or more than 50% of the basic surface area of this partial electrode,
and/or **in that** the contact surface for connection of at least one further electrode, which is not a partial electrode, is equal in size to the contact surface of the partial electrode.

9. Circuit arrangement according to one of the preceding claims, **characterized in that** the metallic sections of a metallization layer (Me1 to Me4) consist of copper, of aluminium, of a copper alloy containing at least 90% copper or an aluminium alloy containing at least 90% aluminium,
and/or **in that** the metallization layers (Me1 to Me4) have a thickness of greater than 100 nm or greater than 150 nm,
and/or **in that** the electrodes in interlayers (ILD1 to ILD3) consist of a metal or of a metal alloy or contain a metal or a metal alloy, in particular a metal nitride, preferably titanium nitride or tantalum nitride,
and/or **in that** at least one electrode in an interlayer (ILD1 to ILD3) has a thickness of less than 100 nm or less than 60 nm,
and/or **in that** contact is made with the electrodes in the interlayers (ILD1 to ILD3) on only one surface, and/or **in that** the interlayers (ILD1 to ILD3) consist of an oxide or contain an oxide, in particular silicon dioxide, or contain a nitride or consist of a nitride, in particular of silicon nitride.

10. Capacitor arrangements (700),
having at least two integrated capacitor arrangements (700) which, apart from geometric designs for defining the position of contact sections (Via1 to Via10), have been produced in accordance with the same geometric designs,
at least one of the two capacitor arrangements (700) being constructed as a capacitor arrangement (700) according to one of the preceding claims,
and at least one contact section (Via1 to Via10) for connection of an electrode (710) being present in one capacitor arrangement (700) and not being present in the other capacitor arrangement, so that at least one electrode in the other capacitor arrangement is not connected.

11. Capacitor arrangements (700) according to Claim 10, **characterized in that** the connected electrode (710) is in the same position with respect to the one capacitor arrangement (700) as the unconnected electrode with respect to the other capacitor arrangement.

## Revendications

1. Circuit intégré comportant un agencement (700, 800) de condensateur,
comprenant au moins trois couches (Me1 à Me4) de métallisation séparées les unes des autres par des couches (ILD1 à ILD3) intermédiaires et comportant des pistes (718, 728) conductrices de connexion de composants électroniques, comprenant des segments (Via1 à Via10) de contact conducteurs de l'électricité, qui sont transversaux aux couches (Me1 à Me4) de métallisation,
comprenant un agencement (700) de condensateur, qui comporte des électrodes (710, 712, 732) connectées par des segments (Via1 à Via10) de contact à deux plaques de condensateur s'interpénétrant,
**caractérisé en ce que** les électrodes (710, 712, 732) de l'agencement (700) de condensateur sont disposées dans au moins deux couches (ILD1 à ILD3) intermédiaires,
**en ce qu'**au moins une électrode de l'agencement (700) de condensateur comporte une sous-électrode (720) se trouvant dans une couche (Me2) de métallisation et une sous-électrode (712) se trouvant dans une couche (ILD1) intermédiaire, les deux sous électrodes (710, 712) étant reliées entre elles d'une manière conductrice de l'électricité par au moins un segment (Via2, Via3) de contact ou par plusieurs segments de contact et
**en ce que** la sous-électrode (720) se trouvant dans la couche Mel à Me4) de métallisation est mise en contact sur des surfaces éloignées l'une de l'autre.

2. Circuit suivant la revendication 1, **caractérisé en ce qu'**au moins une électrode (710) ou une sous-électrode (720) de l'agencement (700) de condensateur se trouve dans une couche (Me1, Me2) de métallisation.

3. Circuit suivant la revendication 1 ou 2, **caractérisé en ce que** des électrodes (712, 722, 732) de l'agencement (700) de condensateur sont disposées dans au moins trois couches (ILD1 à ILD3) intermédiaires ou dans plus de trois couches (ILD1 à ILD3) intermédiaires.

4. Circuit suivant l'une des revendications précédentes, **caractérisé par** au moins une électrode (722) qui est disposée dans une couche (ILD2) intermédiaire et qui a le même contour qu'une autre électrode (732) disposée dans une couche (ILD3) intermédiaire.

5. Circuit suivant la revendication 4, **caractérisé en ce que** les électrodes (722, 732) ayant le même contour sont disposées en alignement (736, 736) sur leurs bords dans une direction normale à une surface de substrat portant l'agencement (700) de condensateur, de préférence le long du même bord.

6. Circuit suivant l'une des revendications 1 à 5, **caractérisé en ce qu'**au moins deux électrodes (822, 824) ou au moins trois électrodes (822 à 826) de l'agencement de condensateur sont disposées entre deux couches (802, 804) de métallisation.

7. Circuit suivant l'une des revendications précédentes, **caractérisé en ce qu'**au moins trois électrodes (822 à 826) se succédant dans l'agencement (800) de condensateur ont été structurées par un nombre de procédés de lithographie qui est plus petit que le nombre des électrodes (822 à 826) qui se succèdent.

8. Circuit suivant l'une des revendications précédentes, **caractérisé en ce que** chaque électrode est reliée à plusieurs segments (Via1 à Via10) de contact,
et/ou **en ce que** la surface de contact d'au moins une sous électrode (722) se trouvant dans une couche (ILD1 à ILD3) intermédiaire représente plus de 30 % ou plus de 50 % de la surface de contour de cette sous-électrode,
et/ou **en ce que** la surface de contact pour la connexion d'au moins une autre électrode, qui n'est pas une sous électrode, est égale à la surface de contact de la sous-électrode.

9. Circuit suivant l'une des revendications précédentes, **caractérisé en ce que** les segments métalliques d'une couche (Me1 à Me4) de métallisation sont en cuivre, en aluminium, en un alliage de cuivre ayant au moins 90 % de cuivre ou en un alliage d'aluminium ayant au moins 90 % d'aluminium,
et/ou **en ce que** les couches (Me1 à Me4) de métallisation ont une épaisseur plus grande que 100 nm ou plus grande que 150 nm,
et/ou **en ce que** les électrodes dans des couches (ILD1 ) ILD3) intermédiaires sont en un métal ou en un alliage métallique ou contiennent un métal ou un alliage métallique, notamment un nitrure métallique, de préférence du nitrure de titane ou du nitrure de tantale,
et/ou **en ce qu'**au moins une électrode dans une couche (ILD1 à ILD3) intermédiaire a une épaisseur plus petite que 100 nm ou plus petite que 60 nm,
et/ou **en ce que** les électrodes dans les couches (ILD1 à ILD3) intermédiaires ne sont mises en contact qui sur une surface,
et/ou **en ce que** les couches (ILD1 à ILD3) intermédiaires sont en un oxyde ou contiennent un oxyde, notamment en dioxyde de silicium ou contiennent un nitrure ou sont en un nitrure, notamment en nitrure de silicium.

10. Agencements (700) de condensateur,
comprenant au moins deux agencements (700) de condensateur intégrés qui, à l'exception des projets géométriques pour la fixation de la position des segments (Via1 à Via10) de contact, ont été fabriqués suivant le même projet géométrique, dans lesquels au moins l'un des deux agencements (700) de condensateur est constitué comme un agencement (700) de condensateur suivant l'une des revendications précédentes,
et dans lesquels au moins un segment (Via1 à Via10) de contact pour la connexion d'une électrode (710) est présent dans l'un des agencements (700) de contact et n'est pas présent dans l'autre agencement de contact de sorte qu'au moins une électrode dans l'autre agencement de condensateur n'est pas connectée.

11. Agencement (700) de condensateur suivant la revendication 10, **caractérisé en ce que** l'électrode (710) connectée a, par rapport à l'un des agencements (700) de condensateur, la même position que l'électrode non connectée par rapport à l'autre agencement de condensateur.
